# EUROPÄISCHE PATENTSCHRIFT

(11) **EP 3 729 562 B1**
(45) Veröffentlichungstag und Bekanntmachung des Hinweises auf die Patenterteilung: **08.09.2021**
(21) Anmeldenummer: 18795999.4
(22) Anmeldetag: 30.10.2018
(51) Int. Cl.: H01R 12/73, H05K 9/00, H01R 12/52, H01R 43/20

(54) **LEITERPLATTENANORDNUNG, VERBINDUNGSELEMENT UND VERFAHREN ZUR MONTAGE WENIGSTENS EINES VERBINDUNGSELEMENTS**
CIRCUIT BOARD ARRANGEMENT, CONNECTION ELEMENT AND METHOD FOR ASSEMBLING AT LEAST ONE CONNECTION ELEMENT
ENSEMBLE FORMANT CARTE DE CIRCUIT IMPRIMÉ, ÉLÉMENT DE LIAISON ET PROCÉDÉ DE MONTAGE D'AU MOINS UN ÉLÉMENT DE LIAISON

(30) Priorität: 21.12.2017 DE 102017130967; 11.01.2018 DE 102018100557
(43) Veröffentlichungstag der Anmeldung: 28.10.2020
(73) Patentinhaber: ROSENBERGER HOCHFREQUENZTECHNIK GMBH & CO. KG, 83413 Fridolfing (DE)
(72) Erfinder: HOEHER, Tobias-Lars, 83329 Waging am See (DE); STADLER, Tobias, 83413 Fridolfing (DE); GRUBER, Andreas, 83404 Ainring (DE)
(74) Vertreter: Lorenz, Markus
(86) Internationale Anmeldenummer: PCT/EP2018/079641
(87) Internationale Veröffentlichungsnummer: WO 2019/120715

(56) Entgegenhaltungen:
- WO-A1-2009/008741
- WO-A1-2010/130655
- GB-A- 2 288 492
- US-A1- 2015 144 376
- US-A1- 2016 079 693

## Beschreibung

Die Erfindung betrifft eine Leiterplattenanordnung, umfassend wenigstens eine erste Leiterplatte und eine zweite Leiterplatte, nach dem Oberbegriff von Anspruch 1.

Die Erfindung betrifft auch ein Verbindungselement für eine Leiterplattenanordnung.

Die Erfindung betrifft außerdem ein Verfahren zur Montage wenigstens eines Verbindungselements in eine vormontierte Leiterplattenanordnung, gemäß dem Oberbegriff von Anspruch 14.

Eine gattungsgemäße Leiterplattenanordnung ist in der US 5,380,211 beschrieben.

Elektrische Baugruppen verfügen in der Regel über elektronische Schaltungen, die auf Leiterplatten ("Printed Circuit Boards", PCBs) durch Verschaltung mehrerer elektronischer Bauelemente implementiert sind. Häufig sind dabei mehrere Leiterplatten innerhalb einer Baugruppe vorgesehen, um eine Schaltung beispielsweise räumlich in einem Gehäuse bzw. einer Umhausung zu verteilen oder unterschiedliche Module einer Baugruppe miteinander zu verbinden. In der Regel ist bei diesem Aufbau eine elektrische Verbindung zwischen den verschiedenen Leiterplatten für einen Signal- und/oder Energieaustausch erforderlich. Eine elektrische Verbindung zwischen verschiedenen Leiterplatten kann beispielsweise auch dann erforderlich sein, wenn mehrere elektronische Baugruppen miteinander kommunikationsverbunden werden sollen. Insgesamt sind die Gründe, mehrere elektrische Leiterplatten miteinander zu verbinden vielfältig.

Zur elektrischen Verbindung von Leiterplatten sind verschiedene Möglichkeiten bekannt, unter anderem ungeschirmte Steckverbinder, Drahtlitzen und Flachbandkabel. Derartige Verbinder sind auch unter der Bezeichnung "Board-to-Board"-Verbinder bekannt. Die herkömmlichen Verbindungen sind in der Regel aber insbesondere für die Hochfrequenztechnik unzureichend.

Um zwei Leiterplatten elektrisch miteinander zu verbinden, werden zur Übertragung von Signalen für die Hochfrequenztechnik häufig koaxiale Steckverbindungen verwendet, um eine ausreichend hohe Signalqualität zu gewährleisten. Dabei wird in der Praxis jeweils ein koaxialer Steckverbinder mittels eines Lötprozesses mit den Streifenleitern der Leiterplatten verbunden. Ein koaxialer Adapter verbindet dann die beiden koaxialen Steckverbinder und überbrückt somit den Abstand zwischen den beiden Leiterplatten, um den Signalaustausch zu ermöglichen. Eine derartige Leiterplattenanordnung ist beispielsweise auch in der gattungsgemäßen US 5,380,211 beschrieben, die einen elektrischen Steckverbinder und insbesondere einen koaxialen Steckverbinder zur elektrischen Verbindung von zwei parallel angeordneten Leiterplatten betrifft. Vergleichbare Verbindungselemente sind beispielsweise auch aus der US 2015/0144376 A1 oder der WO 2009/008741 A1 bekannt.

Ein Nachteil der bekannten Steckverbinder zur Verbindung elektrischer Leiterplatten ist jedoch, dass diese nicht ohne Weiteres nachträglich in bestehende bzw. vormontierte Leiterplattenanordnung integrierbar sind. Dies gilt insbesondere, wenn die zu verbindenden Leiterplatten bereits in eine unabhängige Trägerstruktur aufgenommen und relativ zueinander positioniert sind und/oder in einer oder mehreren Umhausungen aufgenommen sind. Bei den bekannten Steckverbindern ist es also in der Regel erforderlich, die Leiterplattenanordnung in SandwichBauweise aufzubauen, d. h. zunächst den Steckverbinder mit einer der Leiterplatten zu verbinden und erst anschließend die zweite Leiterplatte aufzusetzen. Insbesondere bei zunehmender Bandbreite der Datenübertragung und zunehmender Miniaturisierung der elektronischen Baugruppen ist dieses Konzept technisch unvorteilhaft und auch unflexibel in der Montage.

Zum weiteren, allgemeinen Hintergrund wird außerdem auf die WO 2010/130655 A1 verwiesen, die eine Anordnung zur elektrischen und mechanischen Verbindung zweier Leiterplatten miteinander betrifft. Weiter betrifft die GB 2 288 492 A ein mit einer Leiterplatte verbindbares Adressierungsmodul mit länglichen Kontakten und die US 2016/0079693 A1 einen auf einer Leiterplatte angeordneten Steckverbinder.

Der vorliegenden Erfindung liegt damit die Aufgabe zugrunde den Aufbau einer Leiterplattenanordnung zu vereinfachen.

Der vorliegenden Erfindung liegt auch die Aufgabe zugrunde, ein Verbindungselement für eine Leiterplattenanordnung bereitzustellen, das in besonders einfacher Weise mit einer Leiterplattenanordnung verbindbar ist.

Die Aufgabe wird für die Leiterplattenanordnung durch Anspruch 1 und für das Verbindungselement durch Anspruch 13 gelöst.

Ferner liegt der Erfindung die Aufgabe zugrunde, ein einfaches Verfahren zur Montage wenigstens eines Verbindungselements in eine vormontierte Leiterplattenanordnung bereitzustellen.

Diese Aufgabe wird durch die Merkmale des Anspruchs 14 gelöst.

Die abhängigen Ansprüche betreffen vorteilhafte Ausführungsformen und Varianten der Erfindung.

Die erfindungsgemäße Leiterplattenanordnung umfasst wenigstens eine erste Leiterplatte und eine zweite Leiterplatte, wobei die Leiterplatten in unterschiedlichen Ebenen parallel zueinander verlaufend angeordnet sind.

Insbesondere verlaufen die mit elektrischen Bauteilen bestückbaren Oberflächen der Leiterplatten zueinander parallel.

Die Leiterplattenanordnung kann eine beliebige Anzahl Leiterplatten umfassen, mindestens jedoch zwei. Auch wenn die Erfindung nachfolgend zur Veranschaulichung im Wesentlichen zur Verbindung von zwei elektrischen Leiterplatten beschrieben ist, kann die Leiterplattenanordnung beispielsweise aber auch drei Leiterplatten, vier Leiterplatten, fünf Leiterplatten oder noch mehr Leiterplatten umfassen.

Vorzugsweise sind die miteinander zu verbindenden Leiterplatten in unterschiedlichen Ebenen parallel zueinander angeordnet. Insbesondere eine toleranzbedingte Abweichung von der parallelen Anordnung, beispielsweise von bis zu 10°, vorzugsweise von bis zu 5° und besonders bevorzugt von bis zu 3°, ist vorliegend als von dem Begriff "parallel" umfasst zu verstehen.

Die Leiterplatten können direkt aneinander anliegen oder vorzugsweise voneinander beabstandet sein, insbesondere einen Spalt zwischen einander aufweisen.

Vorzugsweise sind die Leiterplatten deckungsgleich über bzw. untereinander angeordnet, wenn die Leiterplatten identische Dimensionen aufweisen.

Erfindungsgemäß umfasst die Leiterplattenanordnung ferner ein zwischen den Leiterplatten angeordnetes starres Verbindungselement, wobei das Verbindungselement ein Außengehäuse aufweist, das ein Innenleiterteil des Verbindungselements ummantelt.

Das Außengehäuse ummantelt das Innenleiterteil vorzugsweise rohrförmig.

Das Verbindungselement kann vorzugsweise koaxial ausgebildet sein, d. h. derart, dass die Längsachsen des Innenleiterteils und des Außengehäuses aufeinander liegen. Dies ist im Sinne der Erfindung allerdings nicht zwingend erforderlich.

Das Außengehäuse muss nicht vollständig um das Innenleiterteil geschlossen ausgebildet sein und kann das Innenleiterteil im Sinne der Erfindung auch dann ummanteln, wenn es Ausnehmungen, insbesondere Bohrungen und/oder Schlitze umfasst.

Es können auch mehrere Innenleiterteile innerhalb des Außengehäuses vorgesehen sein, beispielsweise zwei, drei, vier, fünf oder noch mehr Innenleiterteile. Besonders bevorzugt wird allerdings nur ein Innenleiterteil verwendet. Zum besseren Verständnis wird die Erfindung nachfolgend mit nur einem Innenleiterteil beschrieben, dies ist jedoch nicht einschränkend zu verstehen.

Erfindungsgemäß ist das Außengehäuse mit einem ersten Ende mit der ersten Leiterplatte und mit einem zweiten Ende mit der zweiten Leiterplatte elektrisch leitfähig verbunden, um einen ersten elektrischen Pfad auszubilden. Das Innenleiterteil ist mit einem ersten Ende mit der ersten Leiterplatte und mit einem zweiten Ende mit der zweiten Leiterplatte elektrisch leitfähig verbunden, um einen zweiten elektrischen Pfad auszubilden.

Die elektrischen Pfade können jeweils zur Übertragung elektrischer Signale, insbesondere hochfrequenter Signale, zur elektrischen Abschirmung und/oder zur elektrischen Energieübertragung verwendbar sein. Zur Ausbildung der elektrischen Pfade müssen das Außengehäuse und das Innenleiterteil nicht vollständig elektrisch leitfähig ausgebildet sein; das Außengehäuse und das Innenleiterteil können auch nur teilweise elektrisch leitfähig ausgebildet sein oder ein elektrisch leitfähiges Material aufweisen derart, dass die elektrischen Pfade ausgebildet werden.

Erfindungsgemäß ist vorgesehen, dass die erste Leiterplatte eine erste Durchgangsbohrung aufweist, wobei die erste Durchgangsbohrung und das Verbindungselement derart ausgestaltet sind, dass das Verbindungselement von einer von der zweiten Leiterplatte abgewandten Außenseite der ersten Leiterplatte in die erste Durchgangsbohrung einführbar ist, wobei ein durch die erste Durchgangsbohrung hindurchgeführtes vorderes Ende des Verbindungselements in einer Endposition des Verbindungselements die zweite Leiterplatte kontaktiert und das Verbindungselement die elektrischen Pfade ausbildet.

Das vordere Ende des Verbindungselements kann insbesondere das Außengehäuse und/oder das Innenleiterteil umfassen.

Das Verbindungselement kann vorzugsweise koaxial ausgebildet sein.

Unter einer Durchgangsbohrung ist im Rahmen der Erfindung auch ein Durchbruch beliebiger Geometrie, beispielsweise auch ein rechteckiger Durchbruch zu verstehen.

Das Verbindungselement kann in eine bereits vormontierte erfindungsgemäße Leiterplattenanordnung eingeführt bzw. eingesteckt werden. Das Verbindungselement kann hierzu mit seinem vorderen Ende zunächst durch die erste Durchgangsbohrung und anschließend durch einen gegebenenfalls vorhandenen Zwischenraum zwischen den Leiterplatten hindurchgeführt werden, bis das vordere Ende die zweite Leiterplatte erreicht.

Insbesondere kann vorgesehen sein, dass das Verbindungselement in seiner Endposition einen Kontaktbereich und/oder eine Kontaktfläche der zweiten Leiterplatte erreicht, um die elektrischen Pfade auszubilden, indem das Außengehäuse und das Innenleiterteil elektrisch mit der zweiten Leiterplatte bzw. deren Kontaktbereich bzw. Kontaktfläche kontaktieren, während diese gleichzeitig mit der ersten Leiterplatte im Bereich eines hinteren Endes des Verbindungselements elektrisch verbunden sind, vorzugsweise ebenfalls durch Kontaktierung eines Kontaktbereichs und/oder einer Kontaktfläche der ersten Leiterplatte. Hierdurch können elektrische Schaltungen der beiden Leiterplatten vorteilhaft miteinander verbunden werden, insbesondere können diese in Folge Signale und/oder elektrische Energie miteinander austauschen.

Vorzugsweise kann das Verbindungselement derart ausgebildet sein, dass zwischen den elektrischen Schaltungen der Leiterplatten mittels des Verbindungselements hochfrequente elektrische Signale austauschbar sind. Die geometrischen und/oder elektrischen Eigenschaften des Außengehäuses und/oder des Innenleiterteils können dementsprechend ausgebildet sein.

Dadurch, dass das Verbindungselement im Gegensatz zu den bekannten Verbindungselementen bzw. Steckverbindern des Standes der Technik auch nachträglich in eine Leiterplattenanordnung eingefügt werden kann, wird die Montage einerseits vereinfacht und andererseits auch ein kompakterer Aufbau der Leiterplattenanordnung möglich. Auch ein nachträglicher Austausch des Verbindungselements, zum Beispiel bei einer Beschädigung oder einer gewünschten Änderung der Verschaltung ist möglich. Es ist auch möglich, einer bestehenden elektrischen Baugruppe nachträglich durch Einfügen des Verbindungselements weitere Funktionalitäten hinzuzufügen bzw. den Funktionsumfang einer elektrischen Baugruppe zu erweitern.

Das Einführen des Verbindungselements ist insbesondere auch dann möglich und vorteilhaft, wenn die Leiterplattenanordnung, ein Teil der Leiterplatten, insbesondere die erste und die zweite Leiterplatte, oder alle Leiterplatten bereits in einer Umhausung bzw. einer Gehäusestruktur aufgenommen sind, wobei es sich um eine elektrisch leitfähige oder eine elektrisch isolierende Umhausung handeln kann. Es kann bei dieser Ausgestaltung vorgesehen sein, dass die jeweilige Umhausung, die die entsprechende Leiterplatte umschließt, eine Zugangsöffnung aufweist, die vorzugsweise koaxial zu der Durchgangsbohrung der von der Umhausung aufgenommenen Leiterplatte angeordnet ist, um das Verbindungselement auch noch in verbautem Zustand nachträglich einfügen zu können.

Eine Umhausung kann beispielsweise als elektrisch leitende Platte mit Bohrungen zur Durchführung des Verbindungselements und/oder als elektrisch leitende Hülse zur Durchführung des Verbindungselements ausgebildet sein oder eine entsprechende Platte und/oder Hülse aufweisen.

Die Umhausung kann als zusätzliche elektromagnetische Schirmung verwendbar sein. Insbesondere wenn das Außengehäuse des Verbindungselements zur elektromagnetischen Abschirmung des Innenleiterteils ausgebildet ist und entsprechend kontaktiert ist, kann die Notwendigkeit einer leitfähigen Umhausung zur Schirmung der Leiterplattenanordnung oder der Leiterplatten entfallen. Die Umhausung kann dann beispielsweise auch aus einem nicht leitfähigen Material ausgebildet sein und in Funktionalität auf eine rein mechanische Funktion beschränkt sein.

In besonders vorteilhafter Weise ist es erfindungsgemäß möglich, Verbindungselemente bereitzustellen, die bereits vollständig vormontiert sind, und insbesondere bereits ein Außengehäuse und ein Innenleiterteil umfassen, vorzugsweise außerdem bereits einen Isolator zwischen Außengehäuse und Innenleiterteil. Die Fehleranfälligkeit während der Montage der Leiterplattenanordnung kann dadurch deutlich verringert werden. Schließlich kann weniger geschultes Personal zur Montage des Verbindungselements in der Leiterplattenanordnung eingesetzt werden. Dies ist insbesondere vorteilhaft, wenn hohe Bandbreiten und erhebliche Miniaturisierung die Datenübertragung erschweren und nur sehr geringe Montagetoleranzen möglich sind.

Das Verbindungselement kann optional diskrete elektrische Bauteile, elektronische Schaltungen, ggf. ebenfalls auf einer Leiterplatte, oder sonstige elektrische Bauteile umfassen, um die elektrische Signalübertragung mittels des ersten und/oder des zweiten elektrischen Pfades flexibel zu beeinflussen, beispielsweise zu verbessern, insbesondere einen Signalpegel zu wandeln, das Signal zu filtern oder auf sonstige Weise zu beeinflussen.

In einer Weiterbildung der Erfindung kann vorgesehen sein, dass die zweite Leiterplatte eine zweite Durchgangsbohrung aufweist, wobei die zweite Durchgangsbohrung und das Verbindungselement derart ausgestaltet sind, dass das vordere Ende des Verbindungselements von der zweiten Durchgangsbohrung aufgenommen wird, wenn sich das Verbindungselement in der Endposition befindet.

Die Leiterplatten können im Sinne der Erfindung parallel zueinander verlaufend ausgerichtet sein, wenn deren Durchgangsbohrungen koaxial zueinander bzw. fluchtend angeordnet sind.

Es kann vorgesehen sein, dass die zweite Durchgangsbohrung in der Endposition des Verbindungselements lediglich das Außengehäuse aufnimmt, lediglich das Innenleiterteil aufnimmt oder das Außengehäuse sowie das Innenleiterteil gemeinsam aufnimmt.

Es ist auch möglich, dass die zweite Leiterplatte keine zweite Durchgangsbohrung aufweist und der vordere Teil des Verbindungselements lediglich auf der zweiten Leiterplatte bzw. auf deren der ersten Leiterplatte zugewandten Innenseite stirnseitig aufsetzt.

In einer Weiterbildung kann vorgesehen sein, dass die erste Durchgangsbohrung und/oder die zweite Durchgangsbohrung jeweils an der Innenfläche wenigstens eine elektrische Kontaktfläche zur Kontaktierung des ersten elektrischen Pfades und/oder des zweiten elektrischen Pfades aufweist bzw. aufweisen.

Die erste Durchgangsbohrung und/oder die zweite Durchgangsbohrung kann bzw. können somit insbesondere als Durchkontaktierungen (sog. "Vias") ausgebildet sein.

Es kann vorgesehen sein, dass das Verbindungselement die erste Leiterplatte insbesondere in der vollständig eingeschobenen Endposition des Verbindungselements kontaktiert, indem das Außengehäuse und/oder das Innenleiterteil von der ersten Durchgangsbohrung aufgenommen und in der ersten Durchgangsbohrung kontaktiert wird bzw. werden.

Es kann außerdem vorgesehen sein, dass das Verbindungselement insbesondere in der Endposition die zweite Leiterplatte kontaktiert, indem das Außengehäuse und/oder das Innenleiterteil von der zweiten Durchgangsbohrung aufgenommen und in der zweiten Durchgangsbohrung kontaktiert wird bzw. werden.

Es kann auch vorgesehen sein, dass die erste und/oder zweite Durchgangsbohrung zur Zentrierung und/oder Fixierung verwendbar ist und hierzu das Außengehäuse und/oder das Innenleiterteil aufnimmt, ggf. ohne einen elektrischen Kontakt herzustellen.

Es kann vorgesehen sein, dass eine Kontaktierung des Außengehäuses und/oder des Innenleiterteils im Bereich der zweiten Leiterplatte stirnseitig erfolgt, beispielsweise auch konventionell mittels Lötung. Auch bei einer stirnseitigen Kontaktierung kann allerdings eine zweite Durchgangsbohrung vorgesehen sein, zumindest als Fügehilfe bzw. zur Zentrierung und/oder Fixierung, beispielsweise indem das Innenleiterteil oder ein Stift von der zweiten Durchgangsbohrung aufgenommen wird.

Beispielsweise kann vorgesehen sein, dass das Außengehäuse und das Innenleiterteil im Bereich der ersten Leiterplatte die Leiterplatte innerhalb der ersten Durchgangsbohrung kontaktiert, wohingegen im Bereich der zweiten Leiterplatte eine stirnseitige Kontaktierung vorgesehen ist.

Im Bereich der Durchgangsbohrungen können Abschirmelemente vorgesehen sein, um die Kontaktflächen in den Durchgangsbohrungen elektromagnetisch abzuschirmen. Die Abschirmelemente können als Durchkontaktierungen in Ausführung als sog. "Plugged Vias", d. h. vollständig mit elektrisch leitfähigem Material gefüllte Durchkontaktierungen, ausgebildet sein.

In einer Weiterbildung der Erfindung kann insbesondere vorgesehen sein, dass die erste Leiterplatte an der von der zweiten Leiterplatte abgewandten Außenseite einen äußeren Kontaktbereich oder an einer der zweiten Leiterplatte zugewandten Innenseite einen inneren Kontaktbereich für die Kontaktierung des zweiten elektrischen Pfades des Verbindungselements aufweist und/oder dass die zweite Leiterplatte an einer von der ersten Leiterplatte abgewandten Außenseite einen äußeren Kontaktbereich oder an einer ersten Leiterplatte zugewandten Innenseite einen inneren Kontaktbereich für die Kontaktierung des zweiten elektrischen Pfades des Verbindungselements aufweist. Dies gilt analog auch für den ersten elektrischen Pfad.

Es kann also vorgesehen sein, dass der zweite elektrische Pfad, der in der Endposition des Verbindungselements mittels des Innenleiterteils zwischen den beiden Leiterplatten ausgebildet wird, zwischen Kontaktbereichen auf einer Oberfläche (Außenseite oder Innenseite) der jeweiligen Leiterplatten ausgebildet wird - im Gegensatz zu einer Kontaktierung einer Kontaktfläche innerhalb der Durchgangsbohrung. Allerdings ist auch eine Kontaktierung innerhalb einer oder innerhalb beider Durchgangsbohrungen möglich, um den zweiten elektrischen Pfad auszubilden. Auch eine gemischte Kontaktierung ist möglich, beispielsweise eine Kontaktierung des ersten Endes des Innenleiterteils mit einer Kontaktfläche innerhalb der ersten Durchgangsbohrung und eine Kontaktierung des zweiten Endes des Innenleiterteils mit einem Kontaktbereich auf der Oberfläche der zweiten Leiterplatte - oder umgekehrt. Dies gilt analog auch für den ersten elektrischen Pfad.

Es kann vorgesehen sein, das Außengehäuse und/oder das Innenleiterteil mit dem inneren und/oder äußeren Kontaktbereich auf der Oberfläche der ersten und/oder zweiten Leiterplatte zu verlöten.

In einer Weiterbildung kann insbesondere vorgesehen sein, dass eine Trägerstruktur der Leiterplattenanordnung die Leiterplatten fixiert und zueinander positioniert.

Bei der Trägerstruktur kann es sich beispielsweise um wenigstens ein Gehäuse bzw. eine Umhausung und/oder wenigstens einen Rahmen handeln. Es können auch weitere elektrische Steckverbinder zur Verbindung der Leiterplatten und/oder Schraub- und Nietverbindungen vorgesehen sein.

In einer Weiterbildung der Erfindung kann vorgesehen sein, dass das Außengehäuse des Verbindungselements zumindest im Bereich zwischen den Leiterplatten elektrisch leitfähig ausgebildet ist und das Innenleiterteil derart ummantelt, dass das Innenleiterteil elektromagnetisch abgeschirmt ist.

Das Außengehäuse kann somit insbesondere in der Art eines Außenleiters das Innenleiterteil elektromagnetisch abschirmen, insbesondere um die störungsfreie Übertragung hochfrequenter elektrischer Signale mittels des Innenleiterteils bzw. durch den zweiten elektrischen Pfad zu ermöglichen.

Das Außengehäuse kann insbesondere mit einer elektrischen Masseverbindung der jeweiligen Leiterplatte elektrisch verbunden sein oder mit einem sonstigen Bezugspotential.

Das Außengehäuse bzw. der erste elektrische Pfad kann grundsätzlich aber auch zur Übertragung eines zusätzlichen elektrischen Signals oder zur Übertragung elektrischer Energie zwischen den Leiterplatten verwendbar sein.

In einer Weiterbildung kann außerdem vorgesehen sein, dass das Außengehäuse des Verbindungselements im Bereich wenigstens eines seiner beiden Enden eine Ausnehmung aufweist, um einen Zugang zu dem Innenleiterteil zu dessen elektrischer Kontaktierung bereitzustellen und/oder um das Innenleiterteil aus dem Außengehäuse zu dessen elektrischer Kontaktierung herauszuführen.

Insbesondere kann das Außengehäuse stirnseitig einen Zugang zu seinem Innenbereich aufweisen, beispielsweise in der Art eines einseitig oder beidseitig geöffneten Rohres. Das Innenleiterteil kann somit aus einem oder aus beiden Enden des Außengehäuses entlang der Längsachse des Außengehäuses herausragen.

Eine Ausnehmung kann alternativ oder ergänzend auch entlang des Außenmantels des Außengehäuses vorgesehen sein, um das Innenleiterteil seitlich aus dem Außengehäuse herauszuführen. Das Außengehäuse kann somit in einem bestimmten Winkelbereich freigelegt sein, um die Durchführung des Innenleiterteils zur Kontaktierung, beispielsweise innerhalb der Durchgangsbohrung, zu ermöglichen.

An dieser Stelle sei vorsorglich erwähnt, dass unter einem "Ende" des Außengehäuses, des Innenleiterteils oder des Verbindungselements vorliegend grundsätzlich ein Endbereich zu verstehen ist, selbst wenn dies nicht explizit erwähnt ist. Unter dem Begriff "Ende" oder dem "Bereich eines Endes" wird im Sinne der Erfindung somit neben dem geometrischen tatsächlichen Ende auch ein Bereich verstanden, der sich ausgehend von dem geometrischen Ende bis zu 30% der Länge des Verbindungselements, des Innenleiterteils und/oder des Außengehäuses in Längsrichtung ausdehnt, beispielsweise bis zu 1%, 2%, 5%, 10%, 15% oder 20% ausdehnt.

In einer Weiterbildung der Erfindung kann ein Isolator innerhalb des Außengehäuses des Verbindungselements vorgesehen sein, um das Außengehäuse und das Innenleiterteil elektrisch voneinander zu isolieren und/oder um das Innenleiterteil in dem Außengehäuse radial und/oder axial zu fixieren.

Ein Isolator bzw. Dielektrikum ist allerdings nicht unbedingt erforderlich. Das Innenleiterteil und das Außengehäuse können grundsätzlich auch so ausgebildet sein, dass diese insbesondere in der Endposition des Verbindungselements zwischen den Leiterplatten ausreichend fixiert sind, um sich gegenseitig nicht zu kontaktieren.

Vorzugsweise wird allerdings ein Isolator verwendet. Es können auch mehrere Isolatoren bzw. ein mehrteiliger Isolator vorgesehen sein. Das Außengehäuse kann zwischen dessen Innenfläche und dem Innenleiterteil vollständig mit einem Isolator ausgefüllt sein oder nur teilweise einen Isolator aufweisen.

In einer Weiterbildung der Erfindung kann vorgesehen sein, dass die erste Durchgangsbohrung einen größeren Durchmesser aufweist, als die zweite Durchgangsbohrung und/oder das erste Ende des Außengehäuses einen größeren Durchmesser aufweist als das zweite Ende des Außengehäuses.

Dadurch, dass die zweite Durchgangsbohrung einen kleineren Durchmesser aufweist als die erste Durchgangsbohrung, kann das vordere Ende des Verbindungselements ebenfalls einen kleineren Durchmesser aufweisen. Das Verbindungselement kann somit mit seinem vorderen Ende einfacher durch die erste Durchgangsbohrung hindurchführbar bzw. einführbar sein, um das Verbindungselement in seine Endposition zu verbringen.

In einer Weiterbildung kann zur Aufnahme des Außengehäuses des Verbindungselements und/oder des Innenleiterteils in der ersten Durchgangsbohrung und/oder in der zweiten Durchgangsbohrung eine Presspassung vorgesehen sein.

Es kann somit vorteilhaft eine Einpresslösung für einen Leiterplattenverbinder, insbesondere einen koaxialen Leiterplattenverbinder, bereitgestellt werden.

Es können Schlitze in Längsrichtung des Verbindungselements, des Außengehäuses und/oder Innenleiterteils vorgesehen sein, um eine Materialverdrängung für die Presspassung zu ermöglichen. Alternativ oder zusätzlich können auch Kerben oder andere Ausnehmungen vorgesehen sein.

Neben einer Presspassung sind auch beliebige sonstige Verbindungstechniken möglich, um das Verbindungselement, das Außengehäuse, das Innenleiterteil und/oder den Isolator insbesondere in der Endposition des Verbindungselements an einer der Leiterplatten oder an eine sonstigen Struktur, beispielsweise auch der Trägerstruktur, zu fixieren. Beispielsweise kann auch eine herkömmliche Lötverbindung oder eine Rastverbindung unter Verwendung von Rastmitteln, beispielsweise Schnapphaken, vorgesehen sein. Das Verbindungselement kann auch in seiner Endposition verklebt werden. Vorzugsweise kann das Verbindungselement in seiner Endposition formschlüssig, kraftschlüssig und/oder stoffschlüssig fixiert werden.

In einer Weiterbildung kann außerdem vorgesehen sein, dass das Verbindungselement im Bereich seines vorderen Endes und/oder im Bereich seines von dem vorderen Ende abgewandten hinteren Endes einen Anschlag aufweist, um eine axiale Bewegung des Verbindungselements über die Endposition hinaus formschlüssig zu blockieren, indem der Anschlag an der Außenseite der ersten Leiterplatte und/oder an der Innenseite der zweiten Leiterplatte anschlägt.

Ferner kann eine mechanische Kodierung vorgesehen sein, um das Verbindungselement nur an einer vorgesehenen Stelle innerhalb der Leiterplattenanordnung einführen zu können und/oder um das Verbindungselement nur in einer definierten Orientierung einführen zu können. Eine mechanische Kodierung kann beispielsweise durch eine asymmetrische Durchgangsbohrung und eine hiermit korrespondierende Geometrie des Außengehäuses bereitgestellt werden.

In einer vorteilhaften Weiterbildung kann vorgesehen sein, dass die erste Durchgangsbohrung und/oder die zweite Durchgangsbohrung zwei elektrisch voneinander isolierte Kontaktflächen aufweist bzw. aufweisen, um sowohl das Außengehäuse als auch das Innenleiterteil innerhalb der Durchgangsbohrung elektrisch mit der Leiterplatte zu verbinden.

Die Kontaktflächen bzw. die Kontaktierung innerhalb der Durchgangsbohrung kann somit unterbrochen sein, um eine elektrisch isolierte Kontaktierung von Innenleiterteil und Außengehäuse zu ermöglichen.

Die erste Durchgangsbohrung und/oder die zweite Durchgangsbohrung kann bzw. können beispielsweise an ihren Innenflächen metallisiert sein, insbesondere in der Art einer Durchkontaktierung, wobei die Metallisierung an zumindest zwei radialen Positionen in Axialrichtung der Durchgangsbohrung unterbrochen ist, um zwei elektrisch nicht miteinander verbundene Kontaktflächen an der Innenfläche der ersten und/oder der zweiten Durchgangsbohrung bereitzustellen.

Es kann beispielsweise vorgesehen sein, dass die Kontaktierung des Innenleiterteils in einer kleineren Bohrung vorgesehen ist, die exzentrisch zur größeren Durchgangsbohrung für die Kontaktierung des Außengehäuses angeordnet ist.

Derartige Durchgangsbohrungen können insbesondere vorteilhaft verwendet werden, um das Außengehäuse und das Innenleiterteil des Verbindungselements gemeinsam in sich aufzunehmen und zur Ausbildung der elektrischen Pfade zu kontaktieren. Eine Kontaktierung des Innenleiterteils kann insbesondere durch das Vorhandensein einer seitlichen Ausnehmung im Bereich des entsprechenden Endes des Außengehäuses zur Durchführung des Innenleiterteils ermöglicht werden.

In einer vorteilhaften Weiterbildung der Erfindung kann ferner vorgesehen sein, dass das Innenleiterteil im Bereich seines ersten Endes aus dem Außengehäuse herausragt, um den äußeren Kontaktbereich der ersten Leiterplatte zu kontaktieren, wenn sich das Verbindungselement in seiner Endposition befindet.

Das Verbindungselement kann mit seinem vorderen Ende derart durch die erste Durchgangsbohrung hindurchgeführt werden, dass das vordere Ende des Verbindungselements die zweite Leiterplatte kontaktiert, wobei in der Endposition außerdem das Innenleiterteil auf der Außenseite der ersten Leiterplatte aufsetzt und dadurch den äußeren Kontaktbereich auf der Oberfläche der ersten Leiterplatte kontaktiert. Das Innenleiterteil kann dabei auch als Endanschlag dienen.

In einer vorteilhaften Weiterbildung der Erfindung kann außerdem das Innenleiterteil im Bereich seines zweiten Endes aus dem Außengehäuse seitlich herausragen, um die innere Kontaktfläche der zweiten Leiterplatte zu kontaktieren, wenn sich das Verbindungselement in seiner Endposition befindet, wobei die erste Durchgangsbohrung eine Durchführung aufweist, um ein Passieren des seitlich herausragenden Innenleiterteils während des Hindurchführens des Verbindungselements durch die erste Durchgangsbohrung zu ermöglichen.

Es kann somit vorgesehen sein, dass das Innenleiterteil, das seitlich aus dem Außengehäuse des Verbindungselements im Bereich des vorderen Endes herausragt in der Endposition des Verbindungselements auf der Innenseite der zweiten Leiterplatte aufsetzt, um die innere Kontaktfläche auf der Oberfläche der zweiten Leiterplatte zu kontaktieren, um den zweiten elektrischen Pfad auszubilden. Das Innenleiterteil kann damit auch als Endanschlag dienen.

Die Durchführung der ersten Durchgangsbohrung kann vorzugsweise als radialer Schlitz und/oder exzentrische, verglichen mit der Durchgangsbohrung, kleine Bohrung ausgebildet sein. Auch andere Ausgestaltungen sind möglich. Es kommt lediglich darauf an, dass das Verbindungselement trotz des seitlich herausragenden Innenleiterteils mit seinem vorderen Ende nach wie vor durch die erste Durchgangsbohrung hindurchführbar ist.

Insbesondere ist auch möglich, dass das Innenleiterteil im Bereich seines ersten Endes aus dem Außengehäuse herausragt, um den äußeren Kontaktbereich der ersten Leiterplatte zu kontaktieren und im Bereich seines zweiten Endes aus dem Außengehäuse seitlich herausragt, um die innere Kontaktfläche der zweiten Leiterplatte zu kontaktieren, wenn sich das Verbindungselement in seiner Endposition befindet.

In diesem Fall kann es vorteilhaft sein sicherzustellen, dass die radiale Ausdehnung des Innenleiterteils, mit der das Innenleiterteil im Bereich seines zweiten Endes aus dem Außengehäuse seitlich herausragt geringer ist als die radiale Ausdehnung, mit der das Innenleiterteil im Bereich seines ersten Endes aus dem Außengehäuse seitlich herausragt, und dass die Durchführung der ersten Durchgangsbohrung derart dimensioniert ist, dass sich das aus dem zweiten Ende des Verbindungselements herausragende Innenleiterteil hindurchführen lässt, nicht jedoch das aus dem ersten Ende herausragende Innenleiterteil, wodurch beide Enden des Innenleiterteils auf den jeweiligen Kontaktbereichen an den Oberflächen der Leiterplatten aufsetzen und diese kontaktieren können.

In einer Weiterbildung kann außerdem vorgesehen sein, dass das Innenleiterteil in einem Grundzustand vollständig innerhalb des Außengehäuses des Verbindungselements angeordnet ist, wobei wenigstens ein Klemmkeil vorgesehen ist, der in das Außengehäuse des Verbindungselements einschiebbar ist und ausgebildet ist, das Innenleiterteil im Bereich wenigstens eines seiner beiden Enden, vorzugsweise im Bereich beider Enden, durch die Ausnehmungen des Außengehäuses herauszubiegen, um den inneren Kontaktbereich wenigstens einer der Leiterplatten zu kontaktieren.

Bei dieser Variante kann es ein besonderer Vorteil sein, dass das Verbindungselement nach dem Herausbiegen der beiden Enden des Innenleiterteils automatisch zwischen den Leiterplatten formschlüssig fixiert ist.

Vorzugsweise ist ein einzelner Klemmkeil vorgesehen, der von einem der beiden Enden des Außengehäuses in das Verbindungselement einschiebbar ist.

Es können aber auch zwei Klemmkeile vorgesehen sein, wobei ein erster Klemmkeil ausgehend von dem ersten Ende des Außengehäuses und ein zweiter Klemmkeil ausgehend von dem zweiten Ende des Außengehäuses in das Verbindungselement einschiebbar ist. Der erste Klemmkeil kann dann vorgesehen sein, um das Innenleiterteil im Bereich seines ersten Endes zu verbiegen, wohingegen der zweite Klemmkeil vorgesehen sein kann, das Innenleiterteil im Bereich seines zweiten Endes zu verbiegen.

Der oder die Klemmkeil(e) kann/können als elektrischer Isolator verwendbar sein.

Der oder die Klemmkeil(e) kann/können nach dessen Verwendung zum Verbiegen des Innenleiterteils in dem Verbindungselement verbleiben oder aus diesem wieder entnehmbar sein. Vorzugsweise verbleibt der wenigstens eine Klemmkeil aber in dem Verbindungselement.

Der Klemmkeil kann ausgehend von der ersten Leiterplatte und/oder von der zweiten Leiterplatte in das Verbindungselement einführbar sein.

In einer Weiterbildung kann das Innenleiterteil im Bereich wenigstens eines seiner beiden Enden elastisch bzw. federnd ausgebildet sein, um eine mechanisch stabile elektrische Kontaktierung mit der Leiterplatte zu ermöglichen.

Beispielsweise kann das Innenleiterteil im Bereich wenigstens eines seiner Enden eine Federlasche aufweisen, die insbesondere für die Hochfrequenztechnik optimiert ist.

Das Innenleiterteil kann somit insbesondere im Kontaktierungsbereich elastisch ausgeformt sein, um einen ausreichenden Kontaktdruck auf eine Kontaktfläche innerhalb der Durchgangsbohrung und/oder auf einen Kontaktbereich auf einer Innen- oder Außenseite der Leiterplatte auszuüben.

Wenn bei einer Ausführungsform mehr als zwei Leiterplatten in der Leiterplattenanordnung vorgesehen sind, kann beispielsweise eine dritte Leiterplatte zwischen der ersten Leiterplatte und der zweiten Leiterplatte angeordnet sein, die eine dritte Durchgangsbohrung aufweist, die koaxial zu der ersten Durchgangsbohrung der ersten Leiterplatte angeordnet ist, wodurch das Verbindungselement mit seinem vorderen Ende ausgehend von der ersten Leiterplatte durch die erste Durchgangsbohrung, anschließend gegebenenfalls durch eine Zwischenraum zwischen der ersten Leiterplatte und der dritten Leiterplatte, anschließend durch die dritte Durchgangsbohrung und wiederum anschließend durch einen gegebenenfalls vorhandenen Zwischenraum zwischen der dritten Leiterplatte und der zweiten Leiterplatte hindurchführbar ist, bis das Verbindungselement die Endposition durch Kontaktieren der zweiten Leiterplatte erreicht. Auf diese Weise können beliebige weitere Leiterplatten in der Leiterplattenanordnung vorgesehen sein, durch die das Verbindungselement hindurchführbar ist. Das Verbindungselement kann dabei ausgebildet sein um auch eine elektrische Kontaktierung mit den weiteren Leiterplatten, beispielsweise der dritten Leiterplatte, insbesondere mittels des Außengehäuses, herzustellen. Schließlich kann das Außengehäuse auch eine weitere Ausnehmung im Bereich der Durchgangsbohrung der weiteren Leiterplatte aufweisen, um auch eine Kontaktierung des Innenleiterteils mit der weiteren Leiterplatte zu ermöglichen, beispielsweise innerhalb deren Durchgangsbohrung oder auf einem äußeren/inneren Kontaktbereich der Oberfläche der weiteren Leiterplatte.

Es können auch mehrere Verbindungselemente innerhalb der erfindungsgemäßen Leiterplattenanordnung vorgesehen sein. Die Anzahl der Verbindungselemente innerhalb der Leiterplattenanordnung ist nicht begrenzt, so können beispielsweise zwei, drei, vier, fünf oder noch mehr Verbindungselemente vorgesehen sein. Die Verbindungselemente können jeweils identisch ausgebildet sein, aber auch einen jeweils unterschiedlichen Aufbau aufweisen. Die Verbindungselemente können auch zur Verbindung unterschiedlicher Leiterplatten vorgesehen sein, wenn mehr als zwei Leiterplatten in der Leiterplattenanordnung vorgesehen sind.

Die Erfindung betrifft auch ein Verbindungselement für eine Leiterplattenanordnung gemäß den vorstehenden Ausführungen.

Bei dem Verbindungselement handelt es sich vorzugsweise nicht um ein Kabel.

Es kann vorgesehen sein, dass das Verbindungselement ausgebildet ist, um einen Versatz im Abstand und/oder Parallelität (bzw. einen sogenannten Winkelversatz) zwischen den Leiterplatten - zumindest in einem geringen Toleranzbereich - auszugleichen.

Die Erfindung betrifft auch ein Verfahren zur Montage wenigstens eines Verbindungselements in eine vormontierte Leiterplattenanordnung umfassend wenigstens eine erste Leiterplatte und eine zweite Leiterplatte, die in unterschiedlichen Ebenen parallel zueinander verlaufend angeordnet sind. Dabei weist das Verbindungselement ein Außengehäuse auf, das ein Innenleiterteil des Verbindungselements ummantelt, wobei das Außengehäuse mit einem ersten Ende mit der ersten Leiterplatte und mit einem zweiten Ende mit der zweiten Leiterplatte elektrisch leitfähig verbunden wird, um einen ersten elektrischen Pfad auszubilden, und wobei das Innenleiterteil mit einem ersten Ende mit der ersten Leiterplatte und mit einem zweiten Ende mit der zweiten Leiterplatte elektrisch leitfähig verbunden wird, um einen zweiten elektrischen Pfad auszubilden. Erfindungsgemäß ist bei dem Verfahren vorgesehen, dass das Verbindungselement zu dessen Montage zwischen den Leiterplatten von einer von der zweiten Leiterplatte abgewandten Außenseite der ersten Leiterplatte in eine erste Durchgangsbohrung eingeführt wird, bis das Verbindungselement eine Endposition in der Leiterplattenanordnung erreicht, in der ein durch die erste Durchgangsbohrung hindurchgeführtes vorderes Ende des Verbindungselements die zweite Leiterplatte kontaktiert und das Verbindungselement die elektrischen Pfade ausbildet.

Vorzugsweise ist das Verbindungselement als starres Verbindungselement ausgebildet. Beispielsweise kann hierzu das Außengehäuse des Verbindungselements unflexibel bzw. starr ausgebildet sein.

In einer Weiterbildung des Verfahrens kann vorgesehen sein, dass in einem zweiten Montageschritt das Innenleiterteil im Bereich wenigstens eines seiner beiden Enden durch eine Ausnehmung in dem Außengehäuse derart herausgebogen wird, dass das Innenleiterteil einen Kontaktbereich auf einer Außenseite oder einer Innenseite wenigstens einer der beiden Leiterplatten kontaktiert.

Das Verbiegen bzw. das Herausbiegen oder Herausdrücken des Innenleiterteils kann grundsätzlich auf beliebige Art und Weise, sogar händisch durch einen Monteur, erfolgen.

In einer bevorzugten Weiterbildung kann allerdings vorgesehen sein, dass wenigstens ein Klemmkeil verwendet wird, der ausgehend von dem ersten Ende und/oder dem zweiten Ende des Außengehäuses des Verbindungselements in das Verbindungselement eingeschoben wird, um das Innenleiterteil zu verbiegen.

Durch Verwendung des wenigstens einen Klemmkeils kann das Innenleiterteil beispielsweise im Bereich der ersten Leiterplatte derart um einen Biegepunkt bzw. ein Drehzentrum eingebogen werden, dass das erste Ende des Innenleiterteils mit ausreichender Kraft gegen den inneren Kontaktbereich der ersten Leiterplatte gedrückt wird, in der Art einer "Wippe".

Im Bereich der zweiten Leiterplatte kann das Innenleiterteil durch den wenigstens einen Klemmkeil vorzugsweise derart gebogen werden, dass es gegen die Innenseite der zweiten Leiterplatte bzw. gegen deren inneren Kontaktbereich gedrückt wird.

Vorzugsweise wird nur ein Klemmkeil verwendet, der in eine Einsteckrichtung, entlang der auch die Montage des Verbindungselements zwischen den Leiterplatten erfolgt, ausgehend von dem ersten Ende des Außenleiters in das Verbindungselement eingeschoben wird. Der Klemmkeil kann aber auch entgegen der Einsteckrichtung einschiebbar sein bzw. eingeschoben werden.

Merkmale, die bereits im Zusammenhang mit der erfindungsgemäßen Leiterplattenanordnung beschrieben wurden, sind selbstverständlich auch für das erfindungsgemäße Verfahren bzw. das Verbindungselement vorteilhaft umsetzbar - und umgekehrt. Ferner können Vorteile, die bereits im Zusammenhang mit der erfindungsgemäßen Leiterplattenanordnung genannt wurden, auch auf das erfindungsgemäße Verfahren bzw. auf das Verbindungselement bezogen verstanden werden - und umgekehrt.

Die Erfindung bzw. die Leiterplattenanordnung, das Verbindungselement und das Verfahren zur Montage des wenigstens einen Verbindungselements sind grundsätzlich für die gesamte Elektrotechnik geeignet. Die Erfindung kann sich allerdings besonders zur Verwendung in der Hochfrequenztechnik eignen.

Die nachfolgend noch dargestellte Lösung stellt eine von der Lösung des Anspruchs 1 unabhängige Erfindung dar. Dabei soll insbesondere aufgezeigt werden, dass das Verbindungselement der vorstehenden Beschreibung in besonderen, nicht bevorzugten Ausgestaltungen auch geeignet sein kann, um Leiterplatten einer Leiterplattenanordnung im Rahmen der SandwichBauweise des Standes der Technik elektrisch miteinander zu verbinden.

Die eigenständige Erfindung betrifft eine Leiterplattenanordnung, umfassend wenigstens eine erste Leiterplatte und eine zweite Leiterplatte, wobei zwischen den Leiterplatten wenigstens ein starres Verbindungselement angeordnet ist, wobei das Verbindungselement ein Außengehäuse aufweist, das ein Innenleiterteil des Verbindungselements ummantelt und wobei das Außengehäuse mit einem ersten Ende mit der ersten Leiterplatte und mit einem zweiten Ende mit der zweiten Leiterplatte elektrisch leitfähig verbunden ist, um einen ersten elektrischen Pfad auszubilden, und wobei das Innenleiterteil mit einem ersten Ende mit der ersten Leiterplatte und mit einem zweiten Ende mit der zweiten Leiterplatte elektrisch leitfähig verbunden ist, um einen zweiten elektrischen Pfad auszubilden. Im Rahmen der eigenständigen Erfindung ist dabei vorgesehen, dass die erste Leiterplatte eine erste Durchgangsbohrung aufweist, wobei die erste Durchgangsbohrung und das Verbindungselement derart ausgestaltet sind, dass das Verbindungselement mit einem hinteren Ende in die erste Durchgangsbohrung einführbar ist, und wobei die zweite Leiterplatte eine zweite Durchgangsbohrung aufweist, wobei die zweite Durchgangsbohrung und das Verbindungselement derart ausgestaltet sind, dass das Verbindungselement mit einem vorderen Ende in die zweite Durchgangsbohrung einführbar ist, wobei das Verbindungselement in einer Endposition, in der dessen Enden von den Durchgangsbohrungen aufgenommen sind, die Leiterplatten kontaktiert, um die elektrischen Pfade auszubilden.

Das vordere und/oder hintere Ende des Verbindungselements kann bzw. können dabei derart ausgestaltet sein, dass diese(s) zwar in die erste und/oder zweite Durchgangsbohrung eingeführt, jedoch nicht vollständig hindurchgeführt werden kann bzw. können.

Insbesondere kann bei der eigenständigen Erfindung vorgesehen sein, dass die erste Durchgangsbohrung und/oder zweite Durchgangsbohrung als Durchkontaktierungen ausgebildet sind und an deren Innenflächen wenigstens eine Kontaktfläche aufweisen, um das Außengehäuse und/oder das Innenleiterteil innerhalb der Durchgangsbohrung elektrisch mit der Leiterplatte zu verbinden.

Insbesondere kann vorgesehen sein, dass die erste Durchgangsbohrung und/oder die zweite Durchgangsbohrung der zweiten Leiterplatte zwei elektrisch voneinander isolierte Kontaktflächen aufweist bzw. aufweisen, um das Außengehäuse als auch das Innenleiterteil innerhalb der Durchgangsbohrung elektrisch mit der Leiterplatte zu verbinden. Dies gilt vorzugsweise für die zweite Durchgangsbohrung.

In einer Variante der eigenständigen Erfindung kann vorgesehen sein, dass die erste Leiterplatte an ihrer der zweiten Leiterplatte zugewandten Innenseite eine innere Kontaktfläche aufweist, um ein im Bereich des hinteren Endes des Verbindungselements seitlich aus dem Außengehäuse herausragendes erstes Ende des Innenleiterteils elektrisch mit der ersten Leiterplatte zu verbinden.

In einer Variante der eigenständigen Erfindung kann außerdem vorgesehen sein, dass die zweite Leiterplatte an deren der ersten Leiterplatte zugewandten Innenseite eine innere Kontaktfläche aufweist, um ein im Bereich des vorderen Endes des Verbindungselements seitlich aus dem Außengehäuse herausragendes zweites Ende des Innenleiterteils elektrisch mit der zweiten Leiterplatte zu verbinden.

Insbesondere kann auch vorgesehen sein, dass beide Enden des Innenleiterteils mit inneren Kontaktflächen der beiden Leiterplatten verbunden sind, um ein Innenleiterteil, das mit seinen beiden Enden im Bereich der Enden des Verbindungselements seitlich aus dem Außengehäuse herausragt, sandwichartig zu kontaktieren.

Grundsätzlich kann das Verbindungselement der eigenständigen Erfindung derart innerhalb der Leiterplattenanordnung montiert werden, dass zunächst das Verbindungselement mit der zweiten Leiterplatte elektrisch verbunden wird und dieses anschließend durch Aufsetzen der ersten Leiterplatte auch mit der ersten Leiterplatte verbunden wird, um die elektrisch leitfähigen Pfade auszubilden.

Die eigenständige Erfindung kann insbesondere vorteilhaft dazu verwendet werden, einen größeren Versatz der Parallelität zwischen den Leiterplatten auszugleichen. Ferner kann der Abstand zwischen den Leiterplatten durch das Verbindungselement bzw. dessen Länge leicht einstellbar sein oder ein Versatz im Abstand korrigiert werden.

Vorteilhafte Ausführungsformen und Weiterbildungen der eigenständigen Erfindung ergeben sich aus den Ausführungen, Weiterbildungen und den offenbarten einzelnen Merkmalen betreffend die Leiterplattenanordnung des Anspruchs 1, das Verbindungselement des Anspruchs 17 und das Verfahren des Anspruchs 18.

Die vorliegende Leiterplattenanordnung, das Verbindungselement und das Verfahren eignen sich für beliebige Anwendungen innerhalb der gesamten Elektrotechnik, können allerdings besonders vorteilhaft im Bereich der Hochfrequenztechnik und der Datenverarbeitung eingesetzt werden, da die Anforderungen an die Elektronik diesbezüglich besonders groß sein können, insbesondere aufgrund der fortdauernden Miniaturisierung und Steigerung der Datenverarbeitungsgeschwindigkeit. Besonders eignet sich die Erfindung für elektronische Einrichtungen mit einem Sandwich-Platinenaufbau. Die Erfindung kann somit besonders vorteilhaft für Basisstationen für Mobilfunknetze, Messgeräte und Messsysteme für die Hochfrequenztechnik und Großrechner mit gestapelten Leiterplatten einsetzbar sein.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von der anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: eine erfindungsgemäße Leiterplattenanordnung mit einer ersten Leiterplatte und einer zweiten Leiterplatte sowie einem erfindungsgemäßen Verbindungselement gemäß einer ersten Ausführungsform;
- Figur 2: ein Verbindungselement in seiner Endposition zwischen zwei Leiterplatten in einer zweiten Ausführungsform in isometrischer Darstellung;
- Figur 3: das Verbindungselement der Figur 2 in einer Schnittdarstellung;
- Figur 4: ein Verbindungselement in seiner Endposition zwischen zwei Leiterplatten in einer dritten Ausführungsform in einer Schnittdarstellung;
- Figur 5: eine Draufsicht auf eine mögliche Ausgestaltung einer Durchgangsbohrung einer Leiterplatte mit einer exzentrischen zweiten Bohrung, welche zwei voneinander elektrisch isolierte Kontaktflächen ausbilden;
- Figur 6: eine Draufsicht auf eine weitere mögliche Ausgestaltung einer Durchgangsbohrung einer Leiterplatte mit zwei voneinander elektrisch isolierten Kontaktflächen;
- Figur 7: ein Verbindungselement in seiner Endposition zwischen zwei Leiterplatten gemäß einer vierten Ausführungsform in einer Schnittdarstellung;
- Figur 8: ein Verbindungselement in seiner Endposition zwischen zwei Leiterplatten in einer fünften Ausführungsform in einer isometrischen Darstellung;
- Figur 9: das Verbindungselement der Figur 8 in einer Schnittdarstellung;
- Figur 10: eine Draufsicht auf eine Leiterplatte mit einem Kontaktbereich und einer Durchgangsbohrung mit einer Kontaktfläche;
- Figur 11: ein Verbindungselement in seiner Endposition zwischen zwei Leiterplatten gemäß einer sechsten Ausführungsform in isometrischer Darstellung;
- Figur 12: das Verbindungselement der Figur 11 in einer Schnittdarstellung;
- Figur 13: eine Draufsicht auf die erste Durchgangsbohrung und den äußeren Kontaktbereich der ersten Leiterplatte der Figur 12;
- Figur 14: ein Verfahren zur Montage eines Verbindungselements gemäß einer siebten Ausführungsform in eine Leiterplattenanordnung während eines ersten Montageschritts;
- Figur 15: das Verfahren der Figur 14 während eines zweiten Montageschritts unter Verwendung eines Klemmkeils;
- Figur 16: die Leiterplattenanordnung der Figuren 14 und 15 nach der Montage des Verbindungselements;
- Figur 17: eine Vergrößerung des Ausschnitts XVII der Figur 15;
- Figur 18: eine Vergrößerung des Ausschnitts XVIII der Figur 15;
- Figur 19: eine Einzeldarstellung des Außengehäuses des Verbindungselements der Figur 14;
- Figur 20: ein Verbindungselement in seiner Endposition zwischen zwei Leiterplatten gemäß einer ersten Variante einer eigenständigen Erfindung in isometrischer Darstellung;
- Figur 21: das Verbindungselement der Figur 20 in einer Schnittdarstellung;
- Figur 22: ein Verbindungselement in seiner Endposition zwischen zwei Leiterplatten gemäß einer zweiten Variante der eigenständigen Erfindung in isometrischer Darstellung; und
- Figur 23: das Verbindungselement der Figur 22 in einer Schnittdarstellung.

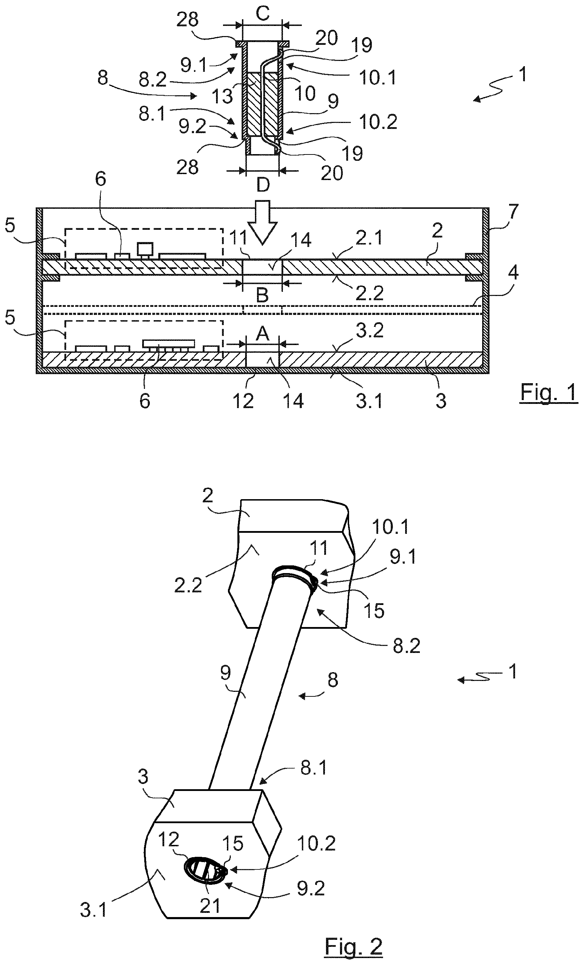

Figur 1 zeigt eine Leiterplattenanordnung 1, umfassend eine erste Leiterplatte 2 und eine zweite Leiterplatte 3, die parallel versetzt zueinander angeordnet sind. Grundsätzlich kann die Erfindung für eine beliebige Anzahl Leiterplatten verwendbar sein, beispielsweise auch drei, vier oder fünf Leiterplatten. Auf die Anzahl Leiterplatten kommt es vorliegend nicht an. Zur Vereinfachung wird die Erfindung nachfolgend unter Bezugnahme auf die erste Leiterplatte 2 und die zweite Leiterplatte 3 beschrieben, hierauf ist die Erfindung jedoch nicht beschränkt. Lediglich beispielhaft ist in Figur 1 gestrichelt eine dritte Leiterplatte 4 angedeutet.

Die Leiterplatten 2, 3, 4 können jeweils elektrische Schaltungen 5, beispielsweise implementiert aus einer Anzahl zusammengeschalteter elektrischer Bauelemente 6 umfassen, wie in Figur 1 im linken Teilbereich der ersten Leiterplatte 2 und der zweiten Leiterplatten 3 angedeutet.

Vorzugsweise kann die Leiterplattenanordnung 1 eine Trägerstruktur 7 umfassen, beispielsweise in der Art einer Umhausung, welche die Leiterplatten 2, 3, 4 fixiert und zueinander positioniert. Eine Trägerstruktur 7 kann allerdings auch entfallen.

Zwischen den Leiterplatten 2, 3, 4 ist wenigstens ein starres Verbindungselement 8 anordenbar, wobei das Verbindungselement 8 ein Außengehäuse 9 aufweist, das ein Innenleiterteil 10 des Verbindungselements 8 vorzugsweise rohrförmig ummantelt. Das Außengehäuse 9 kann dabei vorzugsweise im Wesentlichen geschlossen ausgebildet sein, hierauf kommt es jedoch nicht unbedingt an.

In Figur 1 ist das Verbindungselement 8 zur besseren Darstellung in einem nicht montierten Zustand außerhalb der Leiterplatten 2, 3, 4 gezeigt. Grundsätzlich kann das Außengehäuse 9 des Verbindungselements 8 mit einem ersten Ende 9.1 mit der ersten Leiterplatte 2 und mit einem zweiten Ende 9.2 mit der zweiten Leiterplatte 3 elektrisch leitfähig verbunden sein, um einen ersten elektrischen Pfad auszubilden, wobei das Innenleiterteil 10 mit einem ersten Ende 10.1 mit der ersten Leiterplatte 2 und mit einem zweiten Ende 10.2 mit der zweiten Leiterplatte 3 elektrisch leitfähig verbunden sein kann, um einen zweiten elektrischen Pfad auszubilden.

Dabei ist vorgesehen, dass die erste Leiterplatte 2 eine erste Durchgangsbohrung 11 aufweist, wobei die erste Durchgangsbohrung 11 und das Verbindungselement 8 derart ausgestaltet sind, dass das Verbindungselement 8 von einer von der zweiten Leiterplatte 3 abgewandten Außenseite 2.1 der ersten Leiterplatte 2 in die erste Durchgangsbohrung 11 einführbar ist, wobei ein durch die erste Durchgangsbohrung 11 hindurchgeführtes vorderes Ende 8.1 des Verbindungselements 8 in einer Endposition des Verbindungselements 8 die zweite Leiterplatte 3 kontaktiert und das Verbindungselement 8 die elektrischen Pfade ausbildet.

Vorzugsweise weist die zweite Leiterplatte 3 eine zweite Durchgangsbohrung 12 auf, wobei die zweite Durchgangsbohrung 12 und das Verbindungselement 8 derart ausgestaltet sind, dass das vordere Ende 8.1 des Verbindungselements von der zweiten Durchgangsbohrung 12 aufgenommen wird, wenn sich das Verbindungselement 8 in der Endposition befindet.

Im Ausführungsbeispiel der Figur 1 weist die erste Durchgangsbohrung 11 einen Durchmesser B auf, der größer ist als ein Durchmesser A der zweiten Durchgangsbohrung 12. Das vordere Ende 10.1 des Verbindungselements 8 weist ebenfalls einen Durchmesser D auf, um passgenau in die zweite Durchgangsbohrung 12 aufnehmbar zu sein, wobei ein hinteres Ende 10.2 des Verbindungselements 8 einen Durchmesser C aufweist, der im Wesentlichen dem Durchmesser B der ersten Durchgangsbohrung 11 entspricht, um in dieser passgenau aufnehmbar zu sein. Die erste Durchgangsbohrung 11 kann also einen größeren Durchmesser B aufweisen, als die zweite Durchgangsbohrung 12. Dies ist allerdings nicht zwingend erforderlich. Zur Aufnahme des Außengehäuses 9 des Verbindungselements 8 und/oder des Innenleiterteils 10 in der ersten Durchgangsbohrung 11 und/oder in der zweiten Durchgangsbohrung 12 kann insbesondere eine Presspassung vorgesehen sein.

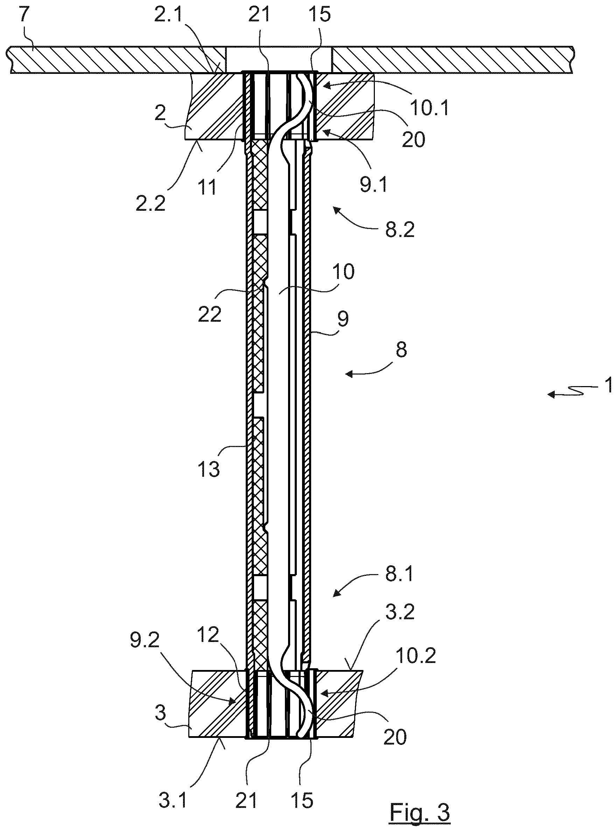

In den Ausführungsbeispielen ist vorgesehen, dass ein Isolator 13 innerhalb des Außengehäuses 9 des Verbindungselements 8 das Außengehäuse 9 und das Innenleiterteil 10 elektrisch voneinander isoliert und/oder das Innenleiterteil 10 in dem Außengehäuse 9 radial und/oder axial fixiert. Der Isolator 13 kann allerdings auch entfallen. Der Isolator 13 kann einstückig ausgebildet sein, wie in Figur 1 dargestellt oder auch mehrteilig ausgebildet sein, wie beispielsweise in der nachfolgenden Figur 3 dargestellt.

Die Leiterplattenanordnung 1 kann auch mehr als ein Verbindungselement 8 umfassen.

Zur Montage des wenigstens einen Verbindungselements 8 kann vorgesehen sein, dass das Verbindungselement 8 von der der zweiten Leiterplatte 3 abgewandten Außenseite 2.1 der ersten Leiterplatte 2 in die erste Durchgangsbohrung 11 eingeführt wird, bis das Verbindungselement 8 seine Endposition in der Leiterplattenanordnung 1 erreicht, in der das durch die erste Durchgangsbohrung 11 durchgeführte vordere Ende 8.1 des Verbindungselements 8 die zweite Leiterplatte 3 kontaktiert und das Verbindungselement 8 die elektrischen Pfade ausbildet. Die Montage erfolgt entlang einer Einsteckrichtung, die in Figur 1 durch einen Pfeil angedeutet ist.

Für die elektrische Kontaktierung in der Endposition sind verschiedene vorteilhafte Ausführungsformen möglich, die in den nachfolgenden Figuren 2 bis 19 näher dargestellt sind und im Folgenden erläutert werden. Grundsätzlich sind die verschiedenen Ausführungsformen beliebig miteinander kombinierbar, sofern dies nicht technisch ausgeschlossen ist.

Die Figuren 2 und 3 zeigen eine Ausführungsform des Verbindungselements 8, das in seiner Endposition zwischen der ersten Leiterplatte 2 und der zweiten Leiterplatte 3 angeordnet ist. Figur 2 zeigt dabei eine isometrische Darstellung, wohingegen Figur 3 einen Schnitt durch das Verbindungselement 8 darstellt.

Grundsätzlich kann vorgesehen sein, dass die erste Durchgangsbohrung 11 und/oder die zweite Durchgangsbohrung 12 jeweils an der Innenfläche wenigstens eine elektrische Kontaktfläche 14 zur Kontaktierung des ersten elektrischen Pfades und/oder des zweiten elektrischen Pfades aufweist bzw. aufweisen. Die Durchgangsbohrungen 11, 12 können somit insbesondere in der Art von Durchkontaktierungen ("Vias") ausgebildet sein. Im Ausführungsbeispiel der Figuren 2 und 3 weisen die erste Durchgangsbohrung 11 und die zweite Durchgangsbohrung 12 jeweils zwei elektrisch voneinander isolierte Kontaktflächen 14 auf, um das Außengehäuse 9 als auch das Innenleiterteil 10 innerhalb der Durchgangsbohrung 11, 12 elektrisch mit der Leiterplatte 2, 3 zu verbinden.

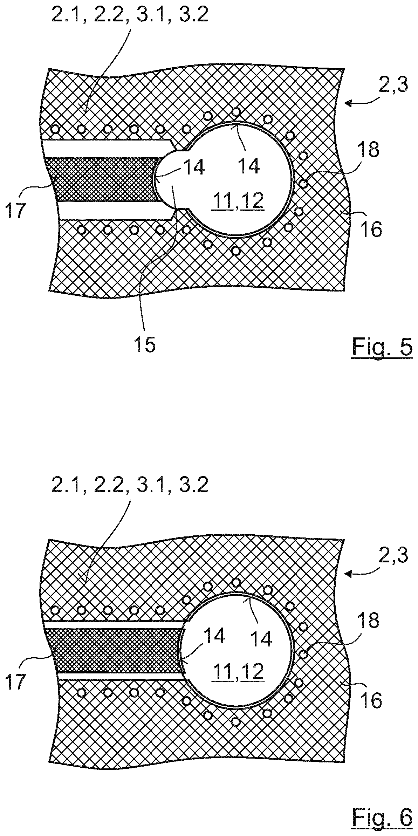

Eine Draufsicht auf eine Durchgangsbohrung 11, 12, die bei den Ausführungsformen der Figuren 2 und 3 Verwendung finden kann, ist in Figur 5 dargestellt. Dabei erfolgt eine Kontaktierung des Innenleiterteils 10 in einer radial versetzt bzw. exzentrisch angeordneten kleineren Bohrung 15. Eine Kontaktierung des Außengehäuses 9 kann direkt im Bereich der Durchgangsbohrung 11, 12 erfolgen. Die Durchgangsbohrung 11, 12 und die exzentrische Bohrung 15 können an deren Innenflächen hierzu zumindest teilweise metallisiert sein und die elektrischen Kontaktflächen 14 ausbilden.

Eine Ausgestaltung der Durchgangsbohrung 11, 12 in der Art der Figur 5 kann auch als mechanische Kodierung verwendbar sein, um das Verbindungselement 8 nur in einer vorgesehenen Orientierung in die Leiterplatten 2, 3, 4 einzustecken.

Das Außengehäuse 9 des Verbindungselements 8 kann vorzugsweise insbesondere zur elektromagnetischen Abschirmung verwendbar sein, ganz besonders dann, wenn das Innenleiterteil 10 zur Übertragung von hochfrequenten elektrischen Signalen verwendbar sein soll. In diesem Fall kann vorgesehen sein, dass das Außengehäuse 9 des Verbindungselements 8 zumindest im Bereich zwischen den Leiterplatten 2, 3, 4 elektrisch leitfähig ausgebildet ist und das Innenleiterteil 10 derart rohrförmig ummantelt, dass das Innenleiterteil 10 elektromagnetisch abgeschirmt ist. Die innere Kontaktfläche 14 der Durchgangsbohrung(en) 11, 12 zur Kontaktierung des Außengehäuses 9 kann dann beispielsweise mit einer Masseleiterbahn 16 der entsprechenden Leiterplatte 2, 3, 4 verbunden sein. Ferner kann die Kontaktfläche 14 zur Kontaktierung des Innenleiterteils 10 mit einer Signalleiterbahn 17 der Leiterplatte 2, 3, 4 verbunden sein, um eine elektrische Verbindung mit der elektrischen Schaltung 5 der Leiterplatte 2, 3, 4 herzustellen.

Anstelle einer exzentrischen Bohrung 15 zur Kontaktierung des Innenleiterteils 10 kann auch eine Durchgangsbohrung 11, 12 in der Art, wie dies in Figur 6 dargestellt ist, vorgesehen sein. Auch in dieser Ausführungsform sind zwei Kontaktflächen 14 vorgesehen. Die Kontaktflächen 14 werden vorliegend ausgebildet, indem die Metallisierung an zwei radialen Positionen innerhalb der Durchgangsbohrung 11, 12 in Axialrichtung der Durchgangsbohrung 11, 12 unterbrochen ist. Eine exzentrische Bohrung 15 ist somit nicht unbedingt erforderlich.

Zur verbesserten Abschirmung kann vorgesehen sein, dass sogenannte "Plugged Vias" 18, insbesondere im Bereich um die Durchgangsbohrung 11, 12 herum angeordnet sind. Dabei handelt es sich in der Regel um vollständig mit Metall gefüllte Durchkontaktierungen, die mit einer Masseleiterbahn in Verbindung stehen.

Zur Kontaktierung des Innenleiterteils 10 innerhalb der Durchgangsbohrung 11, 12 kann das Außengehäuse 9 des Verbindungselements 8 im Bereich wenigstens eines seiner beiden Enden 8.1, 8.2, im Ausführungsbeispiel im Bereich beider Enden 8.1, 8.2, eine Ausnehmung 19 aufweisen (vgl. Figur 1), um einen Zugang zu dem Innenleiterteil 10 zu dessen elektrischer Kontaktierung bereitzustellen. Das Außengehäuse 9 ist somit in einem definierten Winkelbereich geöffnet, aus dem das Innenleiterteil 10 herausragt, um die Kontaktfläche(n) 14 innerhalb der Durchgangsbohrung(en) 11, 12 zu kontaktieren.

Das Innenleiterteil 10 kann wenigstens im Bereich eines seiner beiden Enden 10.1, 10.2 elastisch bzw. federnd ausgebildet sein, um eine mechanisch stabile elektrische Kontaktierung mit der Leiterplatte 2, 3, 4 zu ermöglichen. Hierzu kann das Innenleiterteil 10 im Bereich seiner Enden 10.1, 10.2 Federlaschen 20 aufweisen.

Wie bereits erwähnt, kann das Verbindungselement 8 durch Presspassung in der ersten Leiterplatte 2 und/oder in der zweiten Leiterplatte 3 fixierbar sein. In den Figuren 2 und 3 sind hierzu beispielhaft im Bereich der beiden Enden 9.1, 9.2 des Außengehäuses 9 des Verbindungselements 8 Schlitzungen 21 dargestellt, um eine entsprechende Materialverdrängung zu ermöglichen.

Beispielhaft ist in Figur 3 ein mehrteiliger Isolator 13 dargestellt, der das Innenleiterteil 10 und das Außengehäuse 9 elektrisch voneinander trennt und außerdem das Innenleiterteil 10 radial und axial innerhalb des Außengehäuses 9 fixiert, wofür ein Rücksprung 22 vorgesehen ist, in den das Innenleiterteil 10 eingreift.

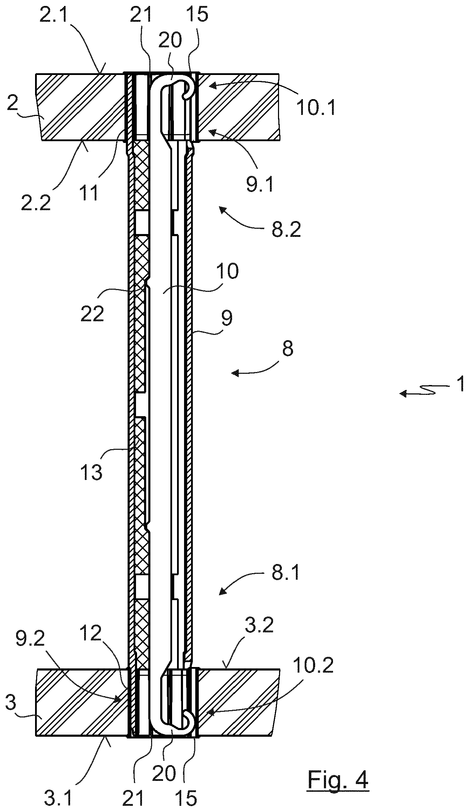

Grundsätzlich kann es von Vorteil sein, wenn das Verbindungselement 8, das Außengehäuse 9 und/oder das Innenleiterteil 10 zur Übertragung von hochfrequenten elektrischen Signalen ausgebildet ist bzw. sind. Insbesondere die Ausgestaltung der Federlaschen 20 zur elektrischen Kontaktierung der Leiterplatten 2, 3, 4 kann hierfür relevant sein. Beispielsweise zeigt Figur 4 eine Ausführungsform des Verbindungselements, das der Ausführungsform der Figur 3 entspricht, bis auf die Gestaltung der Federlaschen 20.

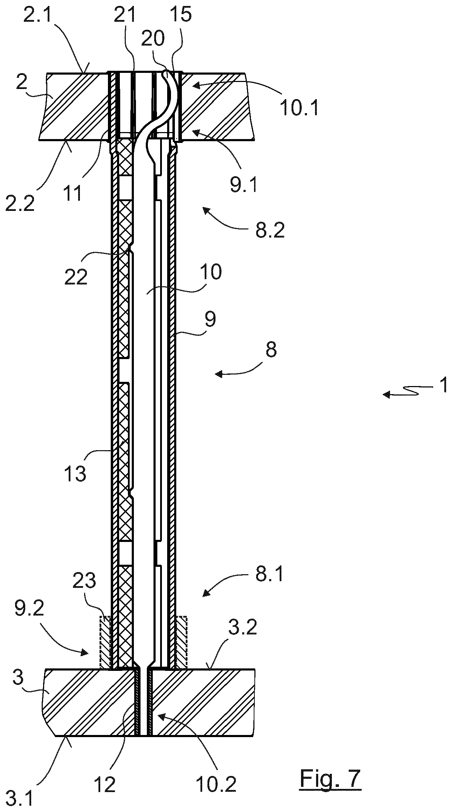

In Figur 7 ist eine vierte Ausführungsform des Verbindungselements 8 dargestellt. Zur Vereinfachung wird lediglich auf die Unterschiede zu den vorhergehenden Ausführungsformen eingegangen. Dies gilt auch für die nachfolgenden Figuren.

Grundsätzlich kann im Bereich der zweiten Leiterplatte 3 auch eine stirnseitige Kontaktierung des Verbindungselements 8 vorgesehen sein, wenn sich das Verbindungselement 8 in seiner Endposition befindet. Dabei kann beispielsweise eine herkömmliche Lötverbindung vorgesehen sein. Im Ausführungsbeispiel der Figur 7 ist zwar ebenfalls eine zweite Durchgangsbohrung 12 vorgesehen, die allerdings nur das Innenleiterteil 10 aufnimmt. Zur Kontaktierung des Innenleiterteils 10 ist diese nicht unbedingt erforderlich. Die zweite Durchgangsbohrung 12 der Ausführungsform der Figur 7 kann auch lediglich der mechanischen Führung und Zentrierung dienen (oder entfallen), insbesondere wenn das Innenleiterteil 10 beispielsweise stirnseitig mit der zweiten Leiterplatte 3 verlötet wird.

Zur Kontaktierung und/oder Führung kann auch, zusätzlich oder alternativ zu einer zweiten Durchgangsbohrung 12, eine Aufnahme oder Steckverbindung 23 vorgesehen sein, in die das vordere Ende 8.1 des Verbindungselements 8 in Einsteckrichtung einsteckbar ist. Dies ist in Figur 7 gestrichelt angedeutet.

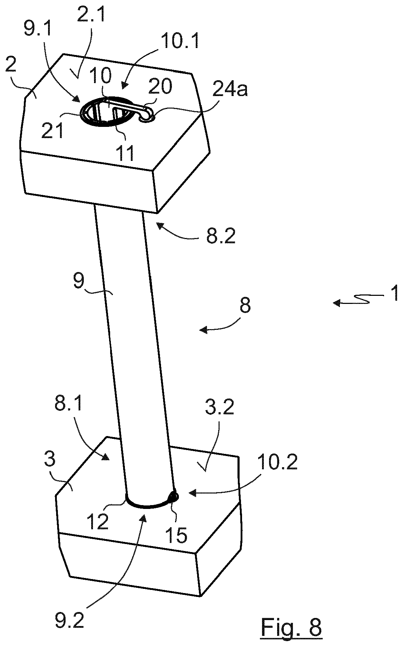

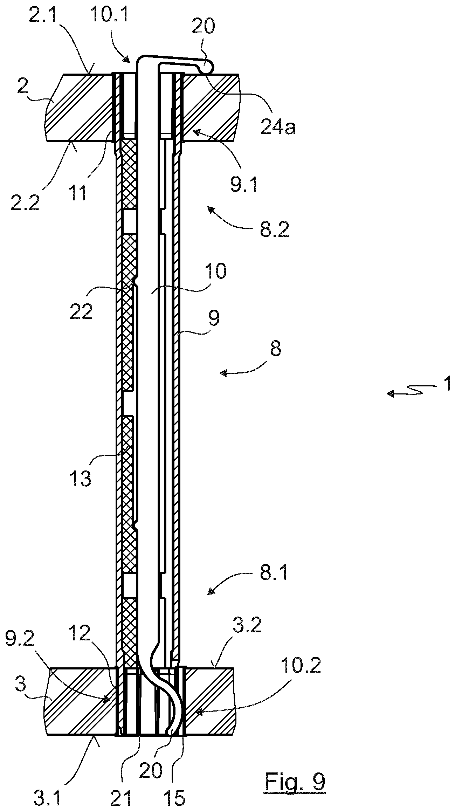

Die Figuren 8 und 9 zeigen eine fünfte Ausführungsform des Verbindungselements 8 in seiner Endposition zwischen der ersten Leiterplatte 2 und der zweiten Leiterplatte 3. Dabei weist die erste Leiterplatte 2 an der von der zweiten Leiterplatte 3 abgewandten Außenseite 2.1 einen äußeren Kontaktbereich 24a für die Kontaktierung des zweiten elektrischen Pfades des Verbindungselements 8 auf, wobei das erste Ende 10.1 des Innenleiterteils 10 bzw. die Federlasche 20 den äußeren Kontaktbereich 24a kontaktiert. Das erste Ende 10.1 des Innenleiterteils 10 ist hierfür aus dem ersten Ende 9.1 des Außengehäuses 9 herausgeführt. Das rohrförmige Außengehäuse 9 ist somit im Bereich seines ersten Endes 9.1 bzw. im Bereich des hinteren Endes 8.2 des Verbindungselements 8 geöffnet.

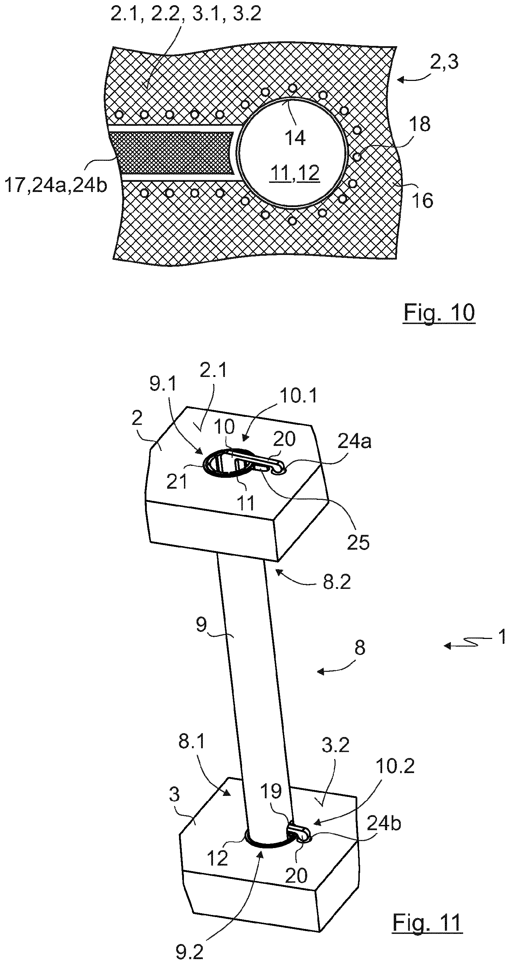

Die Kontaktierung des Außengehäuses 9 findet nach wie vor innerhalb der ersten Durchgangsbohrung 11 statt. Die erste Durchgangsbohrung 11 kann in diesem Fall allerdings vollständig bzw. durchgängig elektrisch leitfähig ausgebildet sein, d. h. eine vollständige zusammenhängende Kontaktfläche 14 zur Kontaktierung des Außengehäuses 9 aufweisen, wie dies in Figur 10 in einer Draufsicht auf eine Durchgangsbohrung 11, 12 dargestellt ist.

Im Ausführungsbeispiel der Figuren 8 und 9 findet die Kontaktierung des Verbindungselements 8 mit der zweiten Leiterplatte 12 dabei nach wie vor statt, wie bereits im Ausführungsbeispiel der Figuren 2 und 3 beschrieben, nämlich innerhalb der zweiten Durchgangsbohrung 12 unter Verwendung zweier voneinander isolierter Kontaktflächen 14.

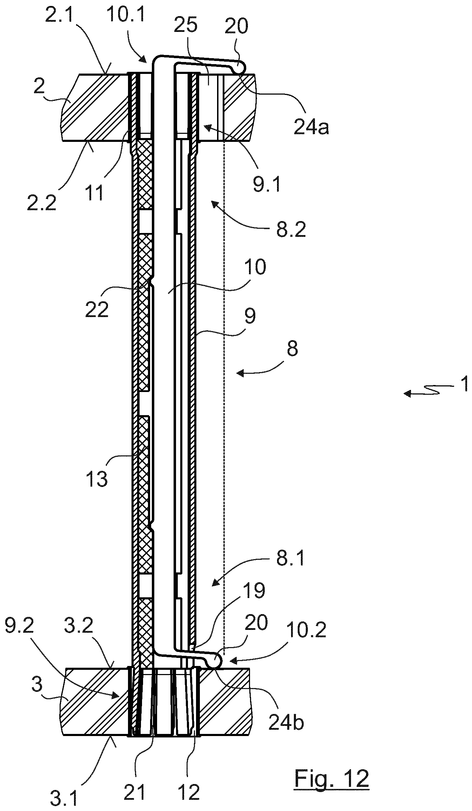

In den Figuren 11 und 12 ist ein weiteres Ausführungsbeispiel dargestellt, bei dem das Innenleiterteil 10 mit seiner im Bereich seines ersten Endes 10.1 angeordneten Federlasche 20 ebenfalls den äußeren Kontaktbereich 24a der ersten Leiterplatte 2 kontaktiert. Die Kontaktierung des Verbindungselements 8 mit der zweiten Leiterplatte 3 weicht allerdings von den vorherigen Ausführungsformen ab. Die zweite Leiterplatte 3 weist an einer der ersten Leiterplatte 2 zugewandten Innenseite 3.2 einen inneren Kontaktbereich 24b für die Kontaktierung des zweiten Endes 10.2 bzw. der Federlasche 20 des Innenleiterteils 10 des Verbindungselements 8 auf. Das Innenleiterteil 10 ist hierzu im Bereich des zweiten Endes 9.2 des Außengehäuses 9 seitlich aus dem Außengehäuse 9 herausgeführt.

Das Innenleiterteil 10 ragt somit im Bereich seines zweiten Endes 10.2 aus dem Außengehäuse 9 seitlich heraus, um die innere Kontaktfläche 24b der zweiten Leiterplatte 3 zu kontaktieren, wenn sich das Verbindungselement 8 in seiner Endposition befindet. Um das Verbindungselement 8 aber nach wie vor mit seinem vorderen Ende 8.1 durch die erste Durchgangsbohrung 11 hindurchführen zu können, weist die erste Durchgangsbohrung 11 eine entsprechend dimensionierte Durchführung 25 auf. Dabei ist sichergestellt, dass das erste Ende 10.1 des Innenleiterteils 10 seitlich weiter aus dem Außengehäuse 9 herausragt, als das zweite Ende 10.2 des Innenleiterteils 10. Hierdurch vermag das Innenleiterteil 10 mit seinem ersten Ende 10.1 den äußeren Kontaktbereich 24a der ersten Leiterplatte 2 zu kontaktieren, da es über die erste Durchgangsbohrung 11 und die Durchführung 25 übersteht. Zur Darstellung der geometrischen Zusammenhänge ist in Figur 12 eine gestrichelte Hilfslinie eingezeichnet.

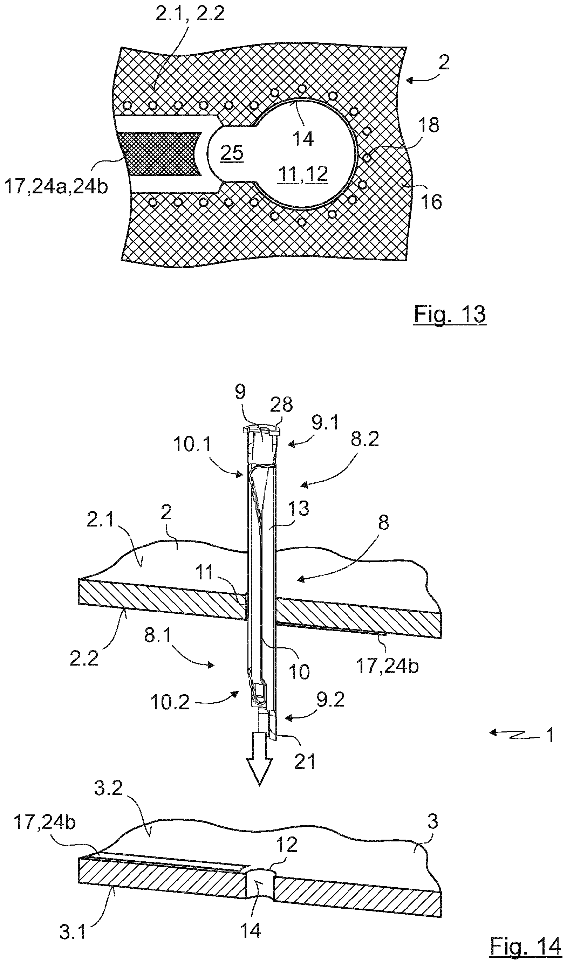

Zur weiteren Verdeutlichung zeigt Figur 13 eine Draufsicht auf die erste Durchgangsbohrung 11, die im Ausführungsbeispiel der Figuren 11 und 12 verwendet wird.

Schließlich zeigen die Figuren 14 bis 18 ein weiteres Ausführungsbeispiel der Erfindung, bei dem das Innenleiterteil 10 in einem Grundzustand vollständig innerhalb des Außengehäuses 9 des Verbindungselements 8 angeordnet ist. Die erste Leiterplatte 2 weist an der der zweiten Leiterplatte 3 zugewandten Innenseite 2.2 einen inneren Kontaktbereich 24b für die Kontaktierung des zweiten elektrischen Pfades bzw. des ersten Endes 10.1 des Innenleiterteils 10 des Verbindungselements 8 auf. Die zweite Leiterplatte 3 weist an der der ersten Leiterplatte 2 zugewandten Innenseite 3.2 ebenfalls einen inneren Kontaktbereich 24b für die Kontaktierung des zweiten elektrischen Pfades bzw. des zweiten Endes 10.2 des Innenleiterteils 10 des Verbindungselements 8 auf. Die Kontaktierung des Außengehäuses 9 erfolgt, wie bereits zuvor, innerhalb der ersten Durchgangsbohrung 11 und auch innerhalb der zweiten Durchgangsbohrung 12.

Figur 14 zeigt eine isometrische Darstellung in einem Teilschnitt, wobei die Montage des Verbindungselements 8 während eines ersten Schrittes dargestellt wird, wonach das Verbindungselement 8 mit seinem vorderen Ende 8.1 zunächst durch die erste Durchgangsbohrung 11 und anschließend durch den Zwischenraum zwischen der ersten Leiterplatte 2 und der zweiten Leiterplatte 3 geführt wird.

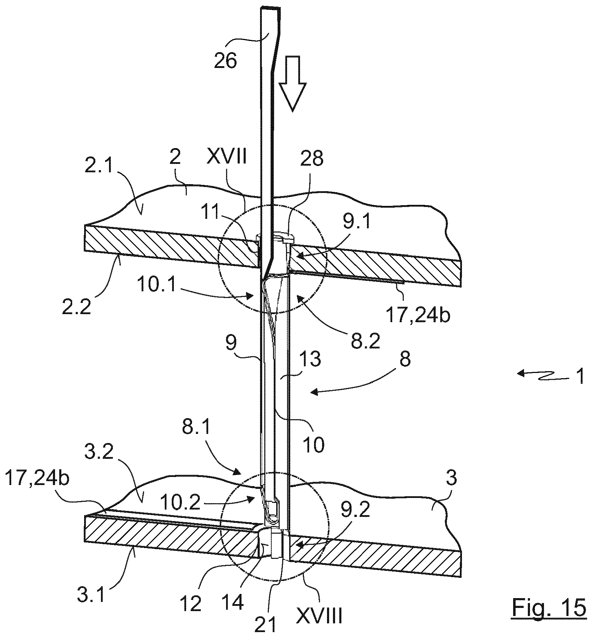

In Figur 15 befindet sich das Verbindungselement 8 bereits in seiner Endposition, wobei das Außengehäuse 9 elektrisch mit beiden Leiterplatten 2, 3 kontaktiert ist, um den ersten elektrischen Pfad auszubilden. Bezüglich der vorhergehenden Ausführungsformen wäre die Montage bereits an dieser Stelle abgeschlossen, da dann auch bereits das Innenleiterteil 10 und somit der zweite elektrische Pfad mit den Leiterplatten 2, 3 verbunden wären. Vorliegend befindet sich das Innenleiterteil 10 allerdings noch in seiner Grundposition innerhalb des Außengehäuses 9.

Bei dieser Ausführungsform ist nun ein Klemmkeil 26 vorgesehen, der in das Außengehäuse 9 des Verbindungselements 8 einschiebbar ist und ausgebildet ist, das Innenleiterteil 10 im Bereich wenigstens eines seiner beiden Enden 10.1, 10.2, vorzugsweise im Bereich beider Enden 10.1, 10.2, durch die Ausnehmungen 19 des Außengehäuses 9 herauszubiegen, um die inneren Kontaktbereiche 24b der Leiterplatten 2, 3 zu kontaktieren. In Figur 15 ist dieser zweite Montageschritt beispielhaft angedeutet, wobei der Klemmkeil 26 ausgehend von dem ersten Ende 9.1 des Außengehäuses 9 des Verbindungselements 8 durch das Verbindungselement 8 geschoben wird, um das Innenleiterteil 10 zu verbiegen. Grundsätzlich kann das Innenleiterteil 10 aber auch auf beliebige andere Art verbiegbar sein. Insbesondere die Verwendung eines Klemmkeils 26 ist nicht unbedingt erforderlich.

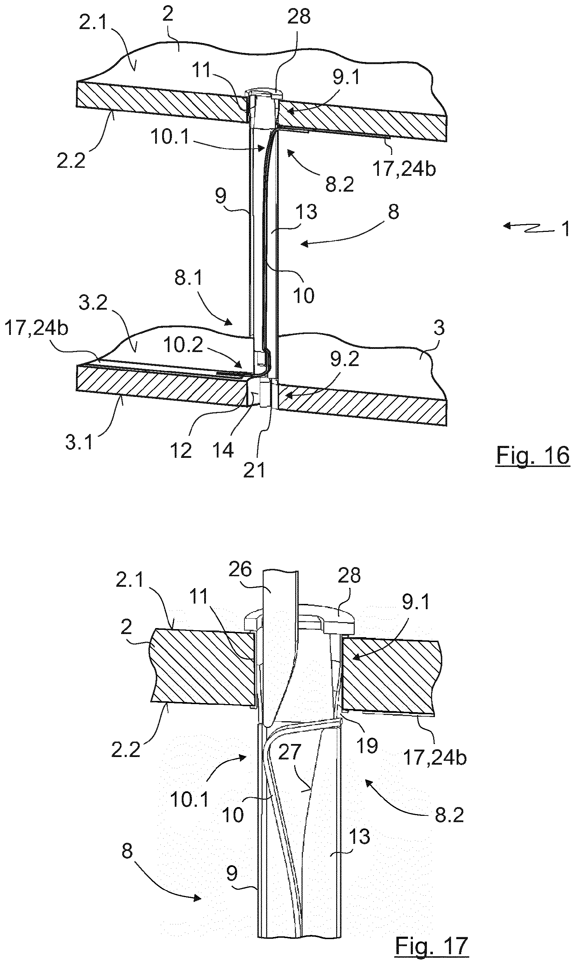

Schließlich zeigt Figur 16 das Verbindungselement 8 in seiner Endposition mit herausgebogenen Enden 10.1, 10.2 des Innenleiterteils 10. In Figur 16 ist der Klemmkeil 26 nicht mehr dargestellt. Nach dem Verbiegen verbleibt der Klemmkeil 26 in dem Außengehäuse 9.

Figur 17 zeigt eine Vergrößerung des Ausschnitts XVII der Figur 15, wobei sich das erste Ende 10.1 des Innenleiterteils 10 noch in seiner Grundposition befindet, bevor es durch den Klemmkeil 26 aus dem Außengehäuse 9 seitlich herausgebogen wird.

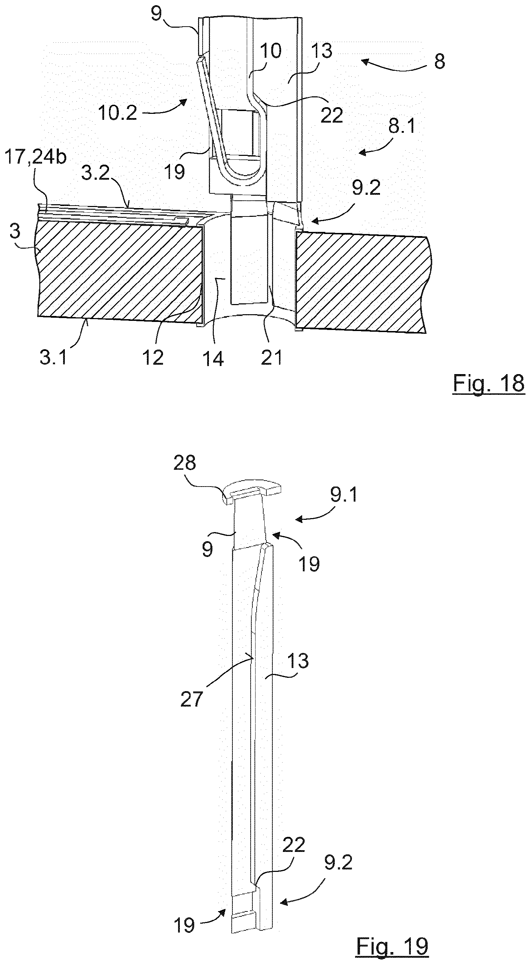

Figur 18 zeigt eine Vergrößerung des Ausschnitts XVIII der Figur 15, wobei sich das Innenleiterteil 10 bzw. das zweite Ende 10.2 des Innenleiterteils 10 noch in seiner Grundposition innerhalb des Außengehäuses 9 befindet, bevor es durch den Klemmkeil 26 aus dem Außengehäuse 9 seitlich herausgebogen wird.

Figur 19 zeigt eine Einzeldarstellung das Außengehäuse 9 in einem isometrischen Teilschnitt. Das Außengehäuse 9 weist einen Isolator 13 mit einer Anlagefläche 27 für das Innenleiterteil 10 auf sowie einen Anschlag 28 im Bereich des hinteren Endes 8.2 des Verbindungselements 8.

Grundsätzlich kann das Verbindungselement 8 im Bereich seines vorderen Endes 8.1 und/oder im Bereich seines von dem vorderen Ende 8.1 abgewandten hinteren Endes 8.2 einen Anschlag 28 aufweisen, um eine axiale Bewegung des Verbindungselements 8 in Einsteckrichtung über die Endposition hinaus formschlüssig zu blockieren, indem der Anschlag 28 an der Außenseite 2.1 der ersten Leiterplatte 2 und/oder an der Innenseite 3.2 der zweiten Leiterplatte 3 anschlägt. Insbesondere im Ausführungsbeispiel der Figur 1 sind die Anschläge 28 ebenfalls gut erkennbar.

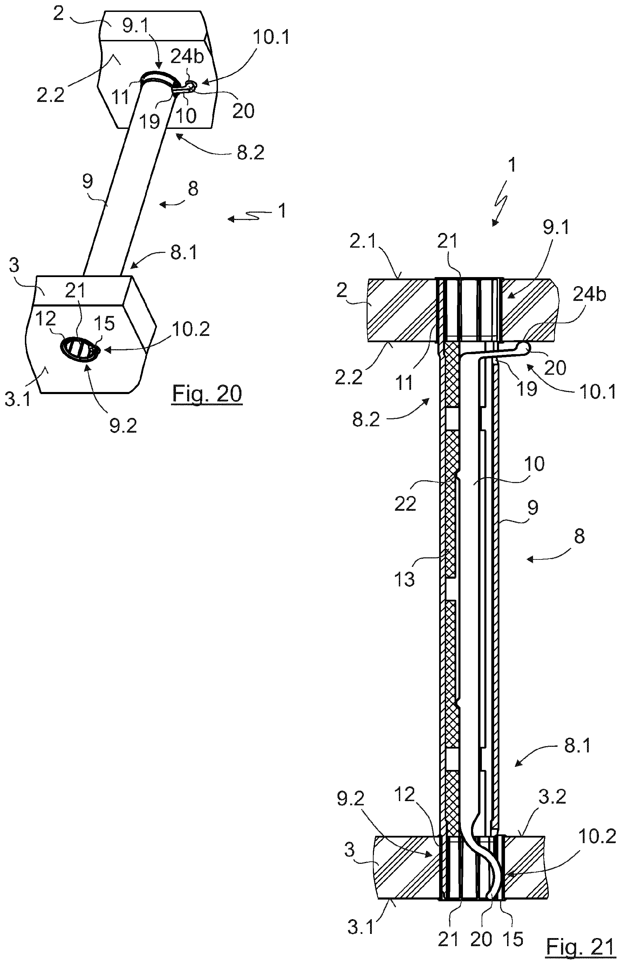

Die Figuren 20 bis 23 zeigen zwei Ausführungsbeispiele einer eigenständigen Erfindung, bei der das Verbindungselement 8 derart modifiziert ist, dass es auch für einen herkömmlichen Sandwichaufbau einer Leiterplattenanordnung 1 verwendbar ist.

Im ersten Ausführungsbeispiel der Figuren 20 und 21 ist vorgesehen, dass die erste Leiterplatte 2 an der der zweiten Leiterplatte 3 zugewandten Innenseite 2.2 einen inneren Kontaktbereich 24b zur Kontaktierung des ersten Endes 10.1 des Innenleiterteils 10 aufweist. Die Kontaktierung des Verbindungselements 8 im Bereich der zweiten Leiterplatte 3 findet, wie bereits beschrieben, vollständig innerhalb der zweiten Durchgangsbohrung 12 statt. Ferner dient die erste Durchgangsbohrung 12 der Kontaktierung des ersten Endes 9.1 des Außengehäuses 9.

Zur Montage des Verbindungselements 8 ist vorgesehen, dass zunächst das Verbindungselement 8 mit seinem vorderen Ende 8.1 in die zweite Durchgangsbohrung 12 der zweiten Leiterplatte 3 eingesteckt wird, bis es seine Endposition erreicht, wonach die erste Leiterplatte 2 auf das hintere Ende 8.2 des Verbindungselements 8 aufgesteckt wird, bis der innere Kontaktbereich 24b das erste Ende 10.1 des Innenleiterteils 10 kontaktiert und beide elektrische Pfade geschlossen sind.

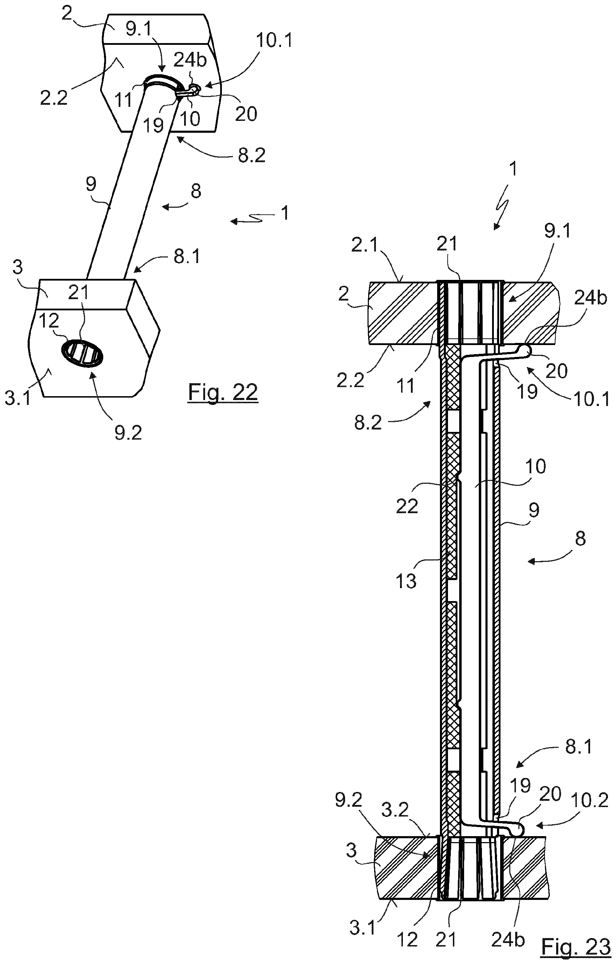

Eine weitere Ausführungsform der eigenständigen Erfindung ist in den Figuren 22 und 23 dargestellt. Das Ausführungsbeispiel entspricht im Wesentlichen dem Ausführungsbeispiel der Figuren 20 und 21, lediglich im Bereich der zweiten Leiterplatte 3 wurde die Kontaktierung modifiziert.

Dementsprechend findet im Bereich der zweiten Leiterplatte 3 eine Kontaktierung des zweiten Endes 10.2 des Innenleiterteils 10 über eine innere Kontaktfläche 24 der zweiten Leiterplatte 3 statt. Die erste Durchgangsbohrung 11 und die zweite Durchgangsbohrung 12 dienen somit lediglich noch der Kontaktierung des Außengehäuses 9 sowie der Zentrierung.

## Patentansprüche

1. Leiterplattenanordnung (1), umfassend wenigstens eine erste Leiterplatte (2) und eine zweite Leiterplatte (3), wobei die Leiterplatten (2, 3, 4) in unterschiedlichen Ebenen parallel zueinander verlaufend angeordnet sind, und wobei zwischen den Leiterplatten (2, 3, 4) wenigstens ein starres Verbindungselement (8) angeordnet ist, wobei das Verbindungselement (8) ein Außengehäuse (9) aufweist, das ein Innenleiterteil (10) des Verbindungselements (8) ummantelt, und wobei das Außengehäuse (9) mit einem ersten Ende (9.1) mit der ersten Leiterplatte (2) und mit einem zweiten Ende (9.2) mit der zweiten Leiterplatte (3) elektrisch leitfähig verbunden ist, um einen ersten elektrischen Pfad auszubilden, und wobei das Innenleiterteil (10) mit einem ersten Ende (10.1) mit der ersten Leiterplatte (2) und mit einem zweiten Ende (10.2) mit der zweiten Leiterplatte (3) elektrisch leitfähig verbunden ist, um einen zweiten elektrischen Pfad auszubilden,
**dadurch gekennzeichnet, dass**
die erste Leiterplatte (2) eine erste Durchgangsbohrung (11) aufweist, wobei die erste Durchgangsbohrung (11) und das Verbindungselement (8) derart ausgestaltet sind, dass das Verbindungselement (8) von einer von der zweiten Leiterplatte (3) abgewandten Außenseite (2.1) der ersten Leiterplatte (2) in die erste Durchgangsbohrung (11) einführbar ist, wobei ein durch die erste Durchgangsbohrung (11) hindurchgeführtes vorderes Ende (8.1) des Verbindungselements (8) in einer Endposition des Verbindungselements (8) die zweite Leiterplatte (3) kontaktiert und das Verbindungselement (8) die elektrischen Pfade ausbildet.

2. Leiterplattenanordnung (1) nach Anspruch 1,
**dadurch gekennzeichnet, dass**
die zweite Leiterplatte (3) eine zweite Durchgangsbohrung (12) aufweist, wobei die zweite Durchgangsbohrung (12) und das Verbindungselement (8) derart ausgestaltet sind, dass das vordere Ende (8.1) des Verbindungselements (8) von der zweiten Durchgangsbohrung (12) aufgenommen wird, wenn sich das Verbindungselement (8) in der Endposition befindet.

3. Leiterplattenanordnung (1) nach Anspruch 1 oder 2,
**dadurch gekennzeichnet, dass**
die erste Durchgangsbohrung (11) und/oder die zweite Durchgangsbohrung (12) jeweils an der Innenfläche wenigstens eine elektrische Kontaktfläche (14) zur Ausbildung des ersten elektrischen Pfades und/oder des zweiten elektrischen Pfades aufweist bzw. aufweisen.

4. Leiterplattenanordnung (1) nach einem der Ansprüche 1 bis 3,
**dadurch gekennzeichnet, dass**
die erste Leiterplatte (2) an der von der zweiten Leiterplatte (3) abgewandten Außenseite (2.1) einen äußeren Kontaktbereich (24a) oder an einer der zweiten Leiterplatte (3) zugewandten Innenseite (2.2) einen inneren Kontaktbereich (24b) für die Kontaktierung des zweiten elektrischen Pfades des Verbindungselements (8) aufweist und/oder dass die zweite Leiterplatte (3) an einer von der ersten Leiterplatte (2) abgewandten Außenseite (3.1) einen äußeren Kontaktbereich (24a) oder an einer der ersten Leiterplatte (2) zugewandten Innenseite (3.2) einen inneren Kontaktbereich (24b) für die Kontaktierung des zweiten elektrischen Pfades des Verbindungselements (8) aufweist.

5. Leiterplattenanordnung (1) nach einem der Ansprüche 1 bis 4,
**dadurch gekennzeichnet, dass**
eine Trägerstruktur (7) vorgesehen ist, welche die Leiterplatten (2, 3, 4) fixiert und zueinander positioniert.

6. Leiterplattenanordnung (1) nach einem der Ansprüche 1 bis 5,
**dadurch gekennzeichnet, dass**
das Außengehäuse (9) des Verbindungselements (8) zumindest im Bereich zwischen den Leiterplatten (2, 3, 4) elektrisch leitfähig ausgebildet ist und das Innenleiterteil (10) derart ummantelt, dass das Innenleiterteil (10) elektromagnetisch abgeschirmt ist.

7. Leiterplattenanordnung (1) nach einem der Ansprüche 1 bis 6,
**dadurch gekennzeichnet, dass**
das Außengehäuse (9) des Verbindungselements (8) im Bereich wenigstens eines seiner beiden Enden (9.1, 9.2) eine Ausnehmung (19) aufweist, um einen Zugang zu dem Innenleiterteil (10) zu dessen elektrischer Kontaktierung bereitzustellen und/oder um das Innenleiterteil (10) aus dem Außengehäuse (9) zu dessen elektrischer Kontaktierung herauszuführen.

8. Leiterplattenanordnung (1) nach einem der Ansprüche 2 bis 7,
**dadurch gekennzeichnet, dass**
die erste Durchgangbohrung (11) einen größeren Durchmesser (B) aufweist, als die zweite Durchgangsbohrung (12) und/oder das erste Ende (9.1) des Außengehäuses (9) einen größeren Durchmesser (C) aufweist als das zweite Ende (9.2) des Außengehäuses (9).

9. Leiterplattenanordnung (1) nach einem der Ansprüche 2 bis 8,
**dadurch gekennzeichnet, dass**
zur Aufnahme des Außengehäuses (9) des Verbindungselements (8) und/oder des Innenleiterteils (10) in der ersten Durchgangsbohrung (11) und/oder in der zweiten Durchgangsbohrung (12) eine Presspassung vorgesehen ist.

10. Leiterplattenanordnung (1) nach einem der Ansprüche 1 bis 9,
**dadurch gekennzeichnet, dass**
das Verbindungselement (8) im Bereich seines vorderen Endes (8.1) und/oder im Bereich seines von dem vorderen Ende (8.1) abgewandten hinteren Endes (8.2) einen Anschlag (28) aufweist, um eine axiale Bewegung des Verbindungselements (8) über die Endposition hinaus formschlüssig zu blockieren, indem der Anschlag (28) an der Außenseite (2.1) der ersten Leiterplatte (2) und/oder an der Innenseite (3.2) der zweiten Leiterplatte (3) anschlägt.

11. Leiterplattenanordnung (1) nach einem der Ansprüche 1 bis 10,
**dadurch gekennzeichnet, dass**
die erste Durchgangsbohrung (11) und/oder die zweite Durchgangsbohrung (12) zwei elektrisch voneinander isolierte Kontaktflächen (14) aufweist, um sowohl das Außengehäuse (9) als auch das Innenleiterteil (10) innerhalb der Durchgangsbohrung (11, 12) elektrisch mit der Leiterplatte (2, 3) zu verbinden.

12. Leiterplattenanordnung (1) nach einem der Ansprüche 4 bis 11,
**dadurch gekennzeichnet, dass**
das Innenleiterteil (10) im Bereich seines ersten Endes (10.1) aus dem Außengehäuse (9) herausragt, um den äußeren Kontaktbereich (24a) der ersten Leiterplatte (2) zu kontaktieren, wenn sich das Verbindungselement (8) in seiner Endposition befindet.

13. Verbindungselement (8) für eine Leiterplattenanordnung (1) gemäß einem der Ansprüche 1 bis 12, wobei das Verbindungselement (8) ein Außengehäuse (9) aufweist, das ein Innenleiterteil (10) des Verbindungselements (8) ummantelt, und wobei das Außengehäuse (9) mit einem ersten Ende (9.1) mit der ersten Leiterplatte (2) und mit einem zweiten Ende (9.2) mit der zweiten Leiterplatte (3) elektrisch leitfähig verbindbar ist, um einen ersten elektrischen Pfad auszubilden, und wobei das Innenleiterteil (10) mit einem ersten Ende (10.1) mit der ersten Leiterplatte (2) und mit einem zweiten Ende (10.2) mit der zweiten Leiterplatte (3) elektrisch leitfähig verbindbar ist, um einen zweiten elektrischen Pfad auszubilden, und wobei das Verbindungselement (8) derart ausgestaltet ist, dass das Verbindungselement (8) von einer von der zweiten Leiterplatte (3) abgewandten Außenseite (2.1) der ersten Leiterplatte (2) in die erste Durchgangsbohrung (11) der ersten Leiterplatte (2) einführbar ist, wobei ein durch die erste Durchgangsbohrung (11) hindurchgeführtes vorderes Ende (8.1) des Verbindungselements (8) in einer Endposition des Verbindungselements (8) die zweite Leiterplatte (3) kontaktiert und das Verbindungselement (8) die elektrischen Pfade ausbildet.

14. Verfahren zur Montage wenigstens eines Verbindungselements (8) in eine vormontierte Leiterplattenanordnung (1) umfassend wenigstens eine erste Leiterplatte (2) und eine zweite Leiterplatte (3), die in unterschiedlichen Ebenen parallel zueinander verlaufend angeordnet sind, wobei das Verbindungselement (8) ein Außengehäuse (9) aufweist, das ein Innenleiterteil (10) des Verbindungselements (8) ummantelt, und wobei das Außengehäuse (9) mit einem ersten Ende (9.1) mit der ersten Leiterplatte (2) und mit einem zweiten Ende (9.2) mit der zweiten Leiterplatte (3) elektrisch leitfähig verbunden wird, um einen ersten elektrischen Pfad auszubilden, und wobei das Innenleiterteil (10) mit einem ersten Ende (10.1) mit der ersten Leiterplatte (2) und mit einem zweiten Ende (10.2) mit der zweiten Leiterplatte (3) elektrisch leitfähig verbunden wird, um einen zweiten elektrischen Pfad auszubilden,
**dadurch gekennzeichnet, dass**
das Verbindungselement (8) zu dessen Montage zwischen den Leiterplatten (2, 3, 4) von einer von der zweiten Leiterplatte (3) abgewandten Außenseite (2.1) der ersten Leiterplatte (2) in eine erste Durchgangsbohrung (11) eingeführt wird, bis das Verbindungselement (8) eine Endposition in der Leiterplattenanordnung (1) erreicht, in der ein durch die erste Durchgangsbohrung (11) durchgeführtes vorderes Ende (8.1) des Verbindungselements (8) die zweite Leiterplatte (3) kontaktiert und das Verbindungselement (8) die elektrischen Pfade ausbildet.

15. Verfahren nach Anspruch 14,
**dadurch gekennzeichnet, dass**
in einem zweiten Montageschritt das Innenleiterteil (10) im Bereich wenigstens eines seiner beiden Enden (10.1, 10.2) durch eine Ausnehmung (19) in dem Außengehäuse (9) derart herausgebogen wird, dass das Innenleiterteil (10) einen Kontaktbereich (24a, 24b) auf einer Außenseite (2.1, 3.1) oder einer Innenseite (2.2, 3.2) wenigstens einer der beiden Leiterplatten (2, 3) kontaktiert.

## Claims

1. A circuit board arrangement (1), comprising at least one first circuit board (2) and a second circuit board (3), wherein the circuit boards (2, 3, 4) are arranged in a parallel orientation to one another in different planes, and wherein at least one rigid connection element (8) is arranged between the circuit boards (2, 3, 4), wherein the connection element (8) comprises an exterior housing (9), which encloses an internal conductor part (10) of the connection element (8), and wherein a first end (9.1) of the exterior housing (9) is connected to the first circuit board (2) and a second end (9.2) of the exterior housing (9) is connected to the second circuit board (3), in an electrically conductive manner, to constitute a first electrical path, and wherein a first end (10.1) of the internal conductor part (10) is connected to the first circuit board (2) and a second end (10.2) of the internal conductor part (10) is connected to the second circuit board (3), in an electrically conductive manner, to constitute a second electrical path,
**characterized in that**
the first circuit board (2) comprises a first through hole (11), wherein the first through hole (11) and the connection element (8) are configured such that the connection element (8) is insertable into the first through hole (11) from an outer side (2.1) of the first circuit board (2) which is averted from the second circuit board (3), wherein a front end (8.1) of the connection element (8) which is fed through the first through hole (11), in a terminal position of the connection element (8), is contact-connected with the second circuit board (3) and the connection element (8) constitutes the electrical paths.

2. The circuit board arrangement (1) as claimed in claim 1,
**characterized in that**
the second circuit board (3) comprises a second through hole (12), wherein the second through hole (12) and the connection element (8) are configured such that the front end (8.1) of the connection element (8) is accommodated by the second through hole (12), when the connection element (8) is located in the terminal position.

3. The circuit board arrangement (1) as claimed in claim 1 or 2,
**characterized in that**
the first through hole (11) and/or the second through hole (12), on the inner surface, respectively comprise at least one electrical contact surface (14) for the constitution of the first electrical path and/or of the second electrical path.

4. The circuit board arrangement (1) as claimed in one of claims 1 to 3,
**characterized in that**
the first circuit board (2), on the outer side (2.1) which is averted from the second circuit board (3), incorporates an outer contact region (24a) or, on an inner side (2.2) which faces the second circuit board (3), incorporates an inner contact region (24b) for the contact-connection of the second electrical path of the connection element (8) and/or **in that** the second circuit board (3), on an outer side (3.1) which is averted from the first circuit board (2), incorporates an outer contact region (24a) or, on an inner side (3.2) which faces the first circuit board (2), incorporates an inner contact region (24b) for the contact-connection of the second electrical path of the connection element (8).

5. The circuit board arrangement (1) as claimed in one of claims 1 to 4,
**characterized in that**
a supporting structure (7) is provided, which secures the circuit boards (2, 3, 4) and positions them in relation to one another.

6. The circuit board arrangement (1) as claimed in one of claims 1 to 5,
**characterized in that**
the exterior housing (9) of the connection element (8), at least in the region between the circuit boards (2, 3, 4), is configured in an electrically conductive manner and encloses the internal conductor part (10) such that the internal conductor part (10) is electromagnetically shielded.

7. The circuit board arrangement (1) as claimed in one of claims 1 to 6,
**characterized in that**
the exterior housing (9) of the connection element (8), in the region of at least one of its two ends (9.1, 9.2), incorporates a cutout (19), in order to provide access to the internal conductor part (10) for the electrical contact-connection thereof and/or in order to bring the internal conductor part (10) out of the exterior housing (9) for the electrical contact-connection thereof.

8. The circuit board arrangement (1) as claimed in one of claims 2 to 7,
**characterized in that**
the first through hole (11) has a larger diameter (B) than the second through hole (12), and/or the first end (9.1) of the exterior housing (9) has a larger diameter (C) than the second end (9.2) of the exterior housing (9).

9. The circuit board arrangement (1) as claimed in one of claims 2 to 8,
**characterized in that**
a press-fit arrangement is provided for the accommodation of the exterior housing (9) of the connection element (8) and/or of the internal conductor part (10) in the first through hole (11) and/or in the second through hole (12).

10. The circuit board arrangement (1) as claimed in one of claims 1 to 9,
**characterized in that**
the connection element (8), in the region of its front end (8.1) and/or in the region of its rear end (8.2), which is averted from the front end (8.1), incorporates a limit stop (28), in order to obstruct axial movement of the connection element (8) beyond the terminal position by a form-fitted arrangement, wherein the limit stop (28) engages with the outer side (2.1) of the first circuit board (2) and/or with the inner side (3.2) of the second circuit board (3).

11. The circuit board arrangement (1) as claimed in one of claims 1 to 10,
**characterized in that**
the first through hole (11) and/or the second through hole (12) comprises two mutually electrically insulated contact surfaces (14), in order to electrically connect both the exterior housing (9) and the internal conductor part (10) to the circuit board (2, 3) within the through hole (11, 12).

12. The circuit board arrangement (1) as claimed in one of claims 4 to 11,
**characterized in that**
the internal conductor part (10), in the region of its first end (10.1), projects out of the exterior housing (9), in order to contact-connect the outer contact region (24a) of the first circuit board (2), when the connection element (8) is located in its terminal position.

13. A connection element (8) for a circuit board arrangement (1) as claimed in one of claims 1 to 12,
wherein the connection element (8) comprises an exterior housing (9) which encloses an internal conductor part (10) of the connection element (8), and wherein a first end (9.1) of the exterior housing (9) can be connected to the first circuit board (2) and a second end (9.2) of the exterior housing (9) can be connected to the second circuit board (3), in an electrically conductive manner, to constitute a first electrical path, and wherein a first end (10.1) of the internal conductor part (10) can be connected to the first circuit board (2) and a second end (10.2) of the internal conductor part (10) can be connected to the second circuit board (3), in an electrically conductive manner, to constitute a second electrical path, and wherein the connection element (8) is configured such that the connection element (8) is insertable into the first through hole (11) of the first circuit board (2) from an outer side (2.1) of the first circuit board (2) which is averted from the second circuit board (3), wherein a front end (8.1) of the connection element (8) which is fed through the first through hole (11), in a terminal position of the connection element (8), is contact-connected with the second circuit board (3) and the connection element (8) constitutes the electrical paths.

14. A method for assembling at least one connection element (8) in a preassembled circuit board arrangement (1) comprising at least one first circuit board (2) and a second circuit board (3), which are arranged in a parallel orientation to one another in different planes, wherein the connection element (8) comprises an exterior housing (9), which encloses an internal conductor part (10) of the connection element (8), and wherein a first end (9.1) of the exterior housing (9) is connected to the first circuit board (2) and a second end (9.2) of the exterior housing (9) is connected to the second circuit board (3), in an electrically conductive manner, to constitute a first electrical path, and wherein a first end (10.1) of the internal conductor part (10) is connected to the first circuit board (2) and a second end (10.2) of the internal conductor part (10) is connected to the second circuit board (3), in an electrically conductive manner, to constitute a second electrical path,
**characterized in that**
the connection element (8), for the assembly thereof between the circuit boards (2, 3, 4), is inserted from an outer side (2.1) of the first circuit board (2), which is averted from the second circuit board (3), into a first through hole (11), until the connection element (8) achieves a terminal position in the circuit board arrangement (1), in which a front end (8.1) of the connection element (8) which is fed through the first through hole (11) contact-connects the second circuit board (3), and the connection element (8) constitutes the electrical paths.

15. The method as claimed in claim 14,
**characterized in that**
in a second assembly step, the internal conductor part (10), in the region of at least one of its two ends (10.1, 10.2), is bent out through a cutout (19) in the exterior housing (9), such that the internal conductor part (10) contact-connects a contact region (24a, 24b) on an outer side (2.1, 3.1) or an inner side (2.2, 3.2) of at least one of the two circuit boards (2, 3).

## Revendications

1. Agencement de circuits imprimés (1) comprenant au moins un premier circuit imprimé (2) et un deuxième circuit imprimé (3), dans lequel les circuits imprimés (2, 3, 4) sont disposés parallèles entre eux dans des plans différents, et dans lequel au moins un élément de liaison (8) rigide est disposé entre les circuits imprimés (2, 3, 4), dans lequel l'élément de liaison (8) présente un boîtier extérieur (9), qui enveloppe une partie conductrice interne (10) de l'élément de liaison (8), et dans lequel le boîtier extérieur (9) est relié de manière électriquement conductrice par une première extrémité (9.1) au premier circuit imprimé (2) et par une seconde extrémité (9.2) au deuxième circuit imprimé (3), pour former un premier chemin électrique, et dans lequel la partie conductrice interne (10) est reliée de manière électriquement conductrice par une première extrémité (10.1) au premier circuit imprimé (2) et par une seconde extrémité (10.2) au deuxième circuit imprimé (3), pour former un second chemin électrique, **caractérisé en ce que**,
le premier circuit imprimé (2) présente un premier trou traversant (11), dans lequel le premier trou traversant (11) et l'élément de liaison (8) sont conçus de sorte que l'élément de liaison (8) peut être introduit, depuis un côté extérieur (2.1) du premier circuit imprimé (2) opposé au deuxième circuit imprimé (3), dans le premier trou traversant (11), dans lequel une extrémité avant (8.1) de l'élément de liaison (8) introduite dans le premier trou traversant (11) entre en contact, dans une position finale de l'élément de liaison (8), avec le deuxième circuit imprimé (3) et l'élément de liaison (8) formant les chemins électriques.

2. Agencement de circuits imprimés (1) selon la revendication 1,
**caractérisé en ce que**,
le deuxième circuit imprimé (3) présente un second trou traversant (12), dans lequel le second trou traversant (12) et l'élément de liaison (8) sont conçus de sorte que l'extrémité avant (8.1) de l'élément de liaison (8) se loge dans le second trou traversant (12) lorsque l'élément de liaison (8) se trouve dans la position finale.

3. Agencement de circuits imprimés (1) selon la revendication 1 ou 2,
**caractérisé en ce que**,
le premier trou traversant (11) et/ou le second trou traversant (12) présente ou présentent sur leurs surfaces internes respectives au moins une surface de contact électrique (14) pour former le premier chemin électrique et/ou le second chemin électrique.

4. Agencement de circuits imprimés (1) selon l'une des revendications 1 à 3,
**caractérisé en ce que**,
le premier circuit imprimé (2) présente, sur le côté extérieur (2.1) opposé au deuxième circuit imprimé (3), une zone de contact externe (24a) ou, sur un côté intérieur (2.2) faisant face au deuxième circuit imprimé (3), une zone de contact interne (24b) pour l'établissement du contact du second chemin électrique de l'élément de liaison (8) et/ou **en ce que** le deuxième circuit imprimé (3) présente, sur un côté extérieur (3.1) opposé au premier circuit imprimé (2), une zone de contact externe (24a) ou, sur un côté intérieur (3.2) faisant face au premier circuit imprimé (2), une zone de contact interne (24b) pour l'établissement du contact du second chemin électrique de l'élément de liaison (8).

5. Agencement de circuits imprimés (1) selon l'une des revendications 1 à 4,
**caractérisé en ce que**,
une structure porteuse (7) est prévue pour immobiliser les circuits imprimés (2, 3, 4) et les positionner l'un par rapport à l'autre.

6. Agencement de circuits imprimés (1) selon l'une des revendications 1 à 5,
**caractérisé en ce que**,
le boîtier extérieur (9) de l'élément de liaison (8) est conçu de manière électriquement conductrice au moins dans la zone entre les circuits imprimés (2, 3, 4) et **en ce que** qu'il enveloppe la partie conductrice interne (10) de sorte à blinder électromagnétiquement la partie conductrice interne (10).

7. Agencement de circuits imprimés (1) selon l'une des revendications 1 à 6, **caractérisé en ce que**,
le boîtier extérieur (9) de l'élément de liaison (8) présente, dans la zone d'au moins l'une de ses deux extrémités (9.1, 9.2,) une ouverture (19) pour permettre l'accès à la partie conductrice interne (10) pour l'établissement de son contact électrique et/ou pour permettre la sortie de la partie conductrice interne (10) hors du boîtier extérieur (9) pour l'établissement de son contact électrique.

8. Agencement de circuits imprimés (1) selon l'une des revendications 2 à 7,
**caractérisé en ce que**,
le premier trou traversant (11) a un diamètre (B) supérieur à celui du second trou traversant (12) et/ou **en ce que** la première extrémité (9.1) du boîtier extérieur (9) a un diamètre (C) supérieur à celui de la seconde extrémité (9.2) du boîtier extérieur (9).

9. Agencement de circuits imprimés (1) selon l'une des revendications 2 à 8,
**caractérisé en ce que**,
un ajustement serré est prévu pour recevoir le boîtier extérieur (9) de l'élément de liaison (8) et/ou la partie conductrice interne (10) dans le premier trou traversant (11) et/ou dans le second trou traversant (12).

10. Agencement de circuits imprimés (1) selon l'une des revendications 1 à 9,
**caractérisé en ce que**,
l'élément de liaison (8) présente, dans la zone de son extrémité avant (8.1) et/ou dans la zone de son extrémité arrière (8.2) opposée à l'extrémité avant (8.1), une butée (28) pour empêcher, par sa forme, un déplacement axial de l'élément de liaison (8) au-delà de la position finale en amenant la butée (28) en contact avec le côté externe (2.1) du premier circuit imprimé (2) et/ou avec le côté interne (3.2) du deuxième circuit imprimé (3).

11. Agencement de circuits imprimés (1) selon l'une des revendications 1 à 10,
**caractérisé en ce que**,
le premier trou traversant (11) et/ou le second trou traversant (12) présente deux surfaces de contact (14) isolées électriquement l'une de l'autre pour permettre de relier électriquement aussi bien le boîtier extérieur (9) que la partie conductrice interne (10) au circuit imprimé (2, 3) à l'intérieur du trou traversant (11, 12).

12. Agencement de circuits imprimés (1) selon l'une des revendications 4 à 11,
**caractérisé en ce que**,
la partie conductrice interne (10) dépasse du boîtier extérieur (9) dans la zone de sa première extrémité (10.1) pour établir le contact avec la zone de contact externe (24a) du premier circuit imprimé (2) lorsque l'élément de liaison (8) est dans sa position finale.

13. Elément de liaison (8) pour un agencement de circuits imprimés (1) selon l'une des revendications 1 à 12, dans lequel l'élément de liaison (8) présente un boitier extérieur (9) enveloppant une partie conductrice interne (10) de l'élément de liaison (8), et dans lequel le boîtier extérieur (9) est relié de manière électriquement conductrice par une première extrémité (9.1) au premier circuit imprimé (2) et par une seconde extrémité (9.2) au deuxième circuit imprimé (3) pour former un premier chemin électrique, et dans lequel la partie conductrice interne (10) est reliée de manière électriquement conductrice par une première extrémité (10.1) au premier circuit imprimé (2) et par une seconde extrémité (10.2) au deuxième circuit imprimé (3) pour former un second chemin électrique, et dans lequel l'élément de liaison (8) est conçu de sorte que l'élément de liaison (8) peut être introduit, depuis un côté extérieur (2.1) du premier circuit imprimé (2) opposé au deuxième circuit imprimé (3), dans le premier trou traversant (11) du premier circuit imprimé (2), dans lequel une extrémité avant (8.1) de l'élément de liaison (8) traversant le premier trou traversant (11) entre en contact, dans une position finale de l'élément de liaison (8), avec le deuxième circuit imprimé (3) et l'élément de liaison (8) formant les chemins électriques.

14. Procédé de montage d'au moins un élément de liaison (8) dans un agencement de circuits imprimés (1) préassemblés comprenant au moins un premier circuit imprimé (2) et un deuxième circuit imprimé (3) disposés parallèles entre eux dans des plans différents, dans lequel l'élément de liaison (8) présente un boîtier extérieur (9) enveloppant une partie conductrice interne (10) de l'élément de liaison (8), et dans lequel le boîtier extérieur (9) est relié de manière électriquement conductrice par une première extrémité (9.1) au premier circuit imprimé (2) et par une seconde extrémité (9.2) au deuxième circuit imprimé (3) pour former un premier chemin électrique, et dans lequel la partie conductrice interne (10) est reliée de manière électriquement conductrice par une première extrémité (10.1) au premier circuit imprimé (2) et par une seconde extrémité (10.2) au deuxième circuit imprimé (3) pour former un second chemin électrique,
**caractérisé en ce que**,
pour son montage entre les circuits imprimés (2, 3, 4), l'élément de liaison (8) est introduit depuis un côté externe (2.1) du premier circuit imprimé (2) opposé au deuxième circuit imprimé (3), dans un premier trou traversant (11) jusqu'à ce que l'élément de liaison (8) atteigne une position finale dans l'agencement de circuits imprimés (1), dans lequel une extrémité avant (8.1) de l'élément de liaison (8) introduite dans le premier trou traversant (11) entre en contact avec le deuxième circuit imprimé (3) et que l'élément de liaison (8) forme les chemins électriques.

15. Procédé selon la revendication 14,
**caractérisé en ce que**,
dans une seconde étape de montage, la partie conductrice interne (10) est cintrée dans la zone d'au moins l'une de ses deux extrémités (10.1, 10.2) pour dépasser du boîtier extérieur (9) par une ouverture (19) de sorte que la partie conductrice interne (10) établisse un contact avec une zone de contact (24a, 24b) sur un côté externe (2.1, 3.1) ou sur un côté interne (2.2, 3.2) d'au moins l'un des deux circuits imprimés (2, 3).
